# EUROPEAN PATENT APPLICATION

(11) **EP 4 404 242 A1**
(43) Date of publication of application: **24.07.2024**
(21) Application number: 22869695.1
(22) Date of filing: 22.07.2022
(51) Int. Cl.: H01L 21/304

(54) **SUBSTRATE PROCESSING DEVICE AND SUBSTRATE PROCESSING METHOD**

(30) Priority: 14.09.2021 JP 2021149253; 05.07.2022 JP 2022108478
(71) Applicant: EBARA CORPORATION, Ota-ku, Tokyo 144-8510 (JP)
(72) Inventor: SATAKE, Masayuki, Tokyo 144-8510 (JP); NAKANISHI, Masayuki, Tokyo 144-8510 (JP); MITSUKI, Yuta, Tokyo 144-8510 (JP)
(74) Representative: Pritzlaff, Stefanie Lydia
(86) International application number: PCT/JP2022/028472
(87) International publication number: WO 2023/042547

(57) **Abstract**

The present invention relates to a substrate processing apparatus and a substrate processing method for processing a laminated substrate manufactured by bonding a plurality of substrates to each other. The substrate processing apparatus has a filler-application module (300) that applies and cures filler (F) to a gap between peripheral portions of adjacent wafers (W1, W2) in a laminated substrate (Ws), a grinding module (400) that grinds an upper surface of the laminated substrate (Ws) to which the filler (F) has been applied, and a polishing module (500) that polishes an upper surface of the laminated substrate (Ws) that has been ground.

## Description

### Technical Field

The present invention relates to a substrate processing apparatus and a substrate processing method for processing a laminated substrate manufactured by bonding a plurality of substrates to each other.

### Background Art

Recently, in order to achieve further higher density and functionality in semiconductor devices, development of three-dimensional packaging technology, in which a plurality of substrates are laminated and integrated three-dimensionally, has been advanced. In the three-dimensional packaging technology, a device surface of a first substrate on which integrated circuits and electrical wiring are formed is, for example, bonded to a device surface of a second substrate on which integrated circuits and electrical wiring are similarly formed. Further, after the first substrate is bonded to the second substrate, the second substrate is thinned by a grinding apparatus. In this manner, integrated circuits can be laminated in the direction perpendicular to the device surfaces of the first and second substrates.

In the three-dimensional packaging technology, three or more substrates may be bonded to each other. For example, a third substrate may be bonded to the second substrate after the second substrate bonded to the first substrate has been thinned, and then the third substrate may be thinned. In this specification, a form in which a plurality of substrates is bonded to each other may be referred to as a "laminated substrate".

### Citation List

### Patent Literature

Patent document 1: Japanese laid-open patent publication No. H05-304062
Patent document 2: U.S. Patent No. 8119500

### Summary of Invention

### Technical Problem

After the second substrate is thinned, the laminated substrate is sent and processed in a post-process, such as dicing process. If flatness of the thinned surface of the second substrate is poor, reliability of the process in the post-process may be decreased, and as a result, manufactured devices may fail to exhibit intended performance.

Furthermore, a filler remaining in the laminated substrate may adversely affect the devices depending on the processing in the post-process. For example, objects detached from the filler may damage the devices, or volatile components from the filler may contaminate the devices. Therefore, the filler is preferably removed from the laminated substrate after the thinning process.

It is therefore an object of the present invention to provide a substrate processing apparatus and a substrate processing method capable of enhancing a flatness of a surface of a laminated substrate after thinning.

### Solution to Problem

In one embodiment, there is provided a substrate processing apparatus for processing a laminated substrate manufactured by bonding a plurality of wafers to each other, comprising: a filler-application module configured to apply and cure a filler to a gap between peripheral portions of adjacent wafers of the plurality of wafers; a grinding module configured to grind an upper surface of the laminated substrate to which the filler has been applied; and a polishing module configured to polish an upper surface of the laminated substrate that has been ground.

In one embodiment, the polishing module comprises: a polishing table configured to support a polishing pad; a polishing head configured to hold the laminated substrate and press the upper surface of the laminated substrate against the polishing pad; and a polishing-liquid supply nozzle configured to supply a polishing liquid to the polishing pad.

In one embodiment, the substrate processing apparatus further comprises: a substrate transfer module configured to transfer the laminated substrate from the grinding module to the polishing module while inverting an upper surface and a lower surface of the laminated substrate.

In one embodiment, the polishing module, the grinding module, and the polishing module are arranged adjacent to each other along a direction of transferring the substrate.

In one embodiment, the substrate processing apparatus further comprises: a finish-polishing module configured to further polishing the laminated substrate that have been polished.

In one embodiment, the finish-polishing module comprises: a polishing table configured to support a polishing pad; a polishing head configured to hold the laminated substrate and to press an upper surface of the laminated substrate against the polishing pad; and a polishing-liquid supply nozzle configured to supply a polishing liquid to the polishing pad.

In one embodiment, the substrate processing apparatus further comprises: a filler-removal module configured to remove the filler from the laminated substrate that has been ground.

In one embodiment, the filler-removal module comprises: a substrate holder configured to hold and rotate the laminated substrate; and a filler-removal unit configured to press a polishing tape against the peripheral portion of the laminated substrate to thereby remove the filler.

In one embodiment, the filler-removal module further comprises: a removal-agent supply mechanism configured to supply a removal agent, which can dissolve the filler, to the laminated substrate.

In one embodiment, the filler-removal module comprises:
a substrate holder configured to hold and rotate the laminated substrate; and
a removal-agent supply mechanism configured to supply a removal agent, which can dissolve the filler, to the laminated substrate.

In one embodiment, the filler-removal module comprises: a buff-process component configured to finish-polish to the upper surface of the laminated substrate that has been polished, the buff-process component comprises: a buff head to which the buff pad for executing a buff process to the upper surface of the laminated substrate is mounted; and a buff arm configured to hold the buff head so as to allow the buff head to swing in a radial direction of the laminated substrate.

In one embodiment, the filler-application module includes: a rotary-holding mechanism configured to hold the laminated substrate in a vertical state; an application module configured to apply the filler into the gap in the laminated substrate above the laminated substrate held by the rotary-holding mechanism; and a curing module configured to cure the filler applied by the application module.

In one embodiment, there is provided a substrate processing method, comprising: taking out a laminated substrate, which is manufactured by bonding a plurality of wafers to each other, from a substrate cassette; applying and curing a filler to a gap between peripheral portions of adjacent wafers of the plurality of wafers; grinding an upper surface of the laminated substrate to which the filler has been applied; polishing an upper surface of the laminated substrate that has been ground; and returning the laminated substrate that has been polished, to the substrate cassette.

In one embodiment, the substrate processing method further comprises: removing the filler from the laminated substrate that has been ground.

In one embodiment, removing the filler is performed after polishing the upper surface of the laminated substrate.

In one embodiment, removing the filler is performed before polishing the upper surface of the laminated substrate.

In one embodiment, removing the filler is removing the filler by pressing a polishing tape against the peripheral portion of the laminated substrate while rotating the laminated substrate.

In one embodiment, removing the filler is performed by supplying a removal agent, which can dissolve the filler, to the laminated substrate while rotating the laminated substrate.

In one embodiment, grinding the upper surface of the laminated substrate and polishing the laminated substrate is performed in the same processing module.

In one embodiment, the substrate processing method further comprises: inverting an upper surface and a lower surface of the laminated substrate after grinding the upper surface of the laminated substrate, wherein polishing of the laminated substrate is pressing the upper surface of the laminated substrate against a polishing pad, while rotating a polishing table configured to support the polishing pad and supplying a polishing liquid onto the polishing pad.

In one embodiment, the substrate processing method further comprises: finish-polishing the upper surface of the laminated substrate after polishing the upper surface of the laminated substrate, wherein finish-polishing of the laminated substrate is pressing the upper surface of the laminated substrate against a polishing pad, while rotating a polishing table configured to support the polishing pad and supplying a polishing liquid onto the polishing pad, and the polishing pad in finish-polishing of the laminated substrate has a finer polishing surface than a polishing surface of the polishing pad in polishing of the laminated substrate.

In one embodiment, the substrate processing method further comprises: finish-polishing the upper surface of the laminated substrate after polishing the upper surface of the laminated substrate, wherein finish-polishing of the laminated substrate is pressing the upper surface of the laminated substrate against a polishing pad, while rotating a polishing table configured to support the polishing pad and supplying a polishing liquid onto the polishing pad, and abrasive grains contained in a polishing liquid for finish-polishing of the laminated substrate have a smaller grain size than abrasive grains contained in a polishing liquid for polishing of the laminated substrate.

In one embodiment, finish-polishing the laminated substrate and removing the filler is performed in the same processing module.

In one embodiment, applying and curing the filler is performed while rotating the laminated substrate held in a vertical state.

### Advantageous Effects of Invention

According to the present inventions, polishing process is performed to the upper surface of the laminated substrate that has been thinned, so that the flatness of the upper surface of the laminated substrate after thinning can be enhanced. As a result, the reliability of post-processing, such as dicing process, is improved, so that occurrence of failers in manufactured devices can be prevented.

### Brief Description of Drawings

[FIG. 1] FIG. 1 is a top view schematically showing a substrate processing apparatus according to one embodiment;
[FIG. 2A] FIG. 2A is an enlarged cross-sectional view showing a peripheral portion of a wafer, which is an example of a substrate;
[FIG. 2B] FIG. 2B is an enlarged cross-sectional view showing a peripheral portion of a wafer, which is an example of a substrate;
[FIG. 3A] FIG. 3A is a schematic view showing an example of a laminated substrate in which two wafers are bonded to each other;
[FIG. 3B] FIG. 3B is a schematic view showing the laminated substrate after the second wafer shown in FIG. 3A has been thinned;
[FIG. 4] FIG. 4 is a plan view showing a filler-application module according to one embodiment;
[FIG. 5] FIG. 5 is a longitudinal cross-sectional view schematically showing the filler-application module shown in FIG. 4;
[FIG. 6] FIG. 6 is a schematic view showing an application module according to one embodiment;
[FIG. 7] FIG. 7 is a schematic view showing a curing module according to one embodiment;
[FIG. 8] FIG. 8 is a schematic view showing a back-grinding module according to one embodiment;
[FIG. 9A] FIG. 9A is a schematic view showing the laminated wafer transported out of the filler-application module;
[FIG. 9B] FIG. 9B is a schematic view showing a state where the second wafer of the laminated wafer shown in FIG. 9A is thinned in the back-grinding module;
[FIG. 10] FIG. 10 is a schematic view showing a polishing module according to one embodiment;
[FIG. 11] FIG. 11 is a schematic view showing the polishing module according to another embodiment;
[FIG. 12] FIG. 12 is a top view schematically showing the substrate processing apparatus according to another embodiment;
[FIG. 13] FIG. 13 is a top view schematically showing the substrate processing apparatus according to still another embodiment;
[FIG. 14] FIG. 14 is a plan view schematically showing a filler-removal apparatus according to one embodiment;
[FIG. 15] FIG. 15 is a view showing a state in which the polishing head is removing the filler;
[FIG. 16A] FIG. 16A is a schematic view showing a state in which the second wafer of the laminated wafer has been thinned;
[FIG. 16B] FIG. 16B is a schematic view showing a state in which the filler has been removed;
[FIG. 17] FIG. 17 is a view showing a state in which the polishing head polishes a bevel portion of the laminated wafer;
[FIG. 18] FIG. 18 is a top view schematically showing a first processing module according to another embodiment;
[FIG. 19] FIG. 19 is a top view schematically showing a fifth processing module according to another embodiment;
[FIG. 20A] FIG. 20A is a cross-sectional view schematically showing an example of the laminated substrate composed of three wafers;
[FIG. 20B] FIG. 20B is a cross-sectional view schematically showing a state in which the upper surface of the laminated substrate shown in FIG. 20A has been ground;
[FIG. 20C] FIG. 20C is a cross-sectional view showing a state in which the filler in the laminated substrate shown in FIG. 20B has been removed;
[FIG. 21A] FIG. 21A is a cross-sectional view schematically showing another example of the laminated substrate composed of three wafers;
[FIG. 21B] FIG. 21B is a cross-sectional view schematically showing a state in which the upper surface of the laminated substrate shown in FIG. 21A is ground;
[FIG. 21C] FIG. 21C is a cross-sectional view showing a state in which the filler is removed from the laminated substrate shown in FIG. 21B;
[FIG. 22] FIG. 22 is a cross-sectional view schematically showing an example of the laminated substrate composed of four wafers;
[FIG. 23] FIG. 23 is a plan view showing the filler-application module according to another embodiment;
[FIG. 24] FIG. 24 is a side view of the filler-application module shown in FIG. 23;
[FIG. 25] FIG. 25 is a side view showing the filler-application module according to still another embodiment;
[FIG. 26] FIG. 26 is a view viewed from a direction indicated by an arrow A in FIG. 25;
[FIG. 27] FIG. 27 is a side view showing the filler-application module according to still another embodiment; and
[FIG. 28] FIG. 28 is a view viewed from a direction indicated by an arrow B in FIG. 27.

### Description of Embodiments

Embodiments will be described below with reference to the drawings.

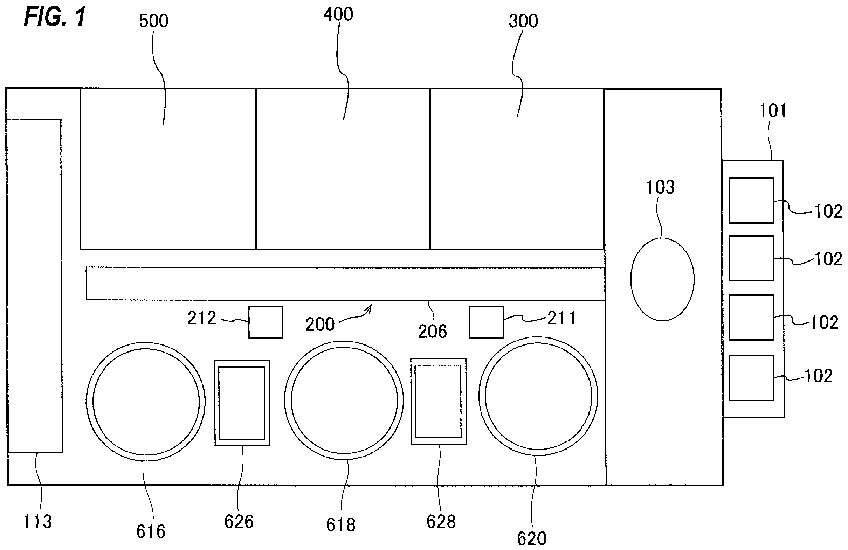

FIG. 1 is a top view schematically showing a substrate processing apparatus according to one embodiment. The substrate processing apparatus shown in FIG. 1 is an apparatus for processing a laminated wafer, which is an example of a laminated substrate. This substrate processing apparatus has a loading-and-unloading section 101 including two or more (four, for example) front loading units 102 on which wafer cassettes, each storing plural wafers (substrates), are placed. Each of the front loading units 102 is capable of receiving thereon an open cassette, an SMIF (Standard Manufacturing Interface) pod, or a FOUP (Front Opening Unified Pod). The SMIF and FOUP are a hermetically sealed container which can house a wafer cassette therein and is covered with a partition wall to thereby provide interior environments isolated from an external space.

In the loading-and-unloading section 101, a first transfer robot (or a loader) 103 is installed, which is movable along an arrangement direction of the front loading units 102. The first transfer robot 103 is configured to be able to access the wafer cassettes placed in each of the front loading units 102, and to take out the laminated wafer from the wafer cassette.

The substrate processing apparatus further includes a second transfer robot 206, and a first wafer station 211 and a second wafer station 212 disposed on both sides of the second transfer robot 206. The second transfer robot 206, the first wafer station 211, and the second wafer station 212 serve as the substrate transfer module 200.

Further, the substrate processing apparatus includes a plurality (three in FIG. 1) of processing modules 300, 400, and 500 arranged adjacent to the transfer robot 206, and a controller 113 configured to control the entire operation of the substrate processing apparatus. In this embodiment, the processing modules 300, 400, and 500 are arranged along the longitudinal direction of the substrate processing apparatus. Detailed configurations of the processing modules 300, 400, and 500 will be described below.

Furthermore, the substrate processing apparatus includes a first cleaning module 616 and a second cleaning module 618 configured to clean the laminated wafer, and a drying module 620 configured to dry the cleaned laminated wafer. The first cleaning module 616, the second cleaning module 618, and the drying module 620 are arranged along the longitudinal direction of the substrate processing apparatus.

A second substrate transfer robot 626 is disposed between the first cleaning module 616 and the second cleaning module 618, and configured to transfer the laminated wafer between these cleaning modules 616, 618 and the substrate transfer module 200. A third substrate transfer robot 628 is disposed between the second cleaning module 618 and the drying module 620, and configured to transfer the laminated wafer between these modules 618 and 620.

The type of first cleaning module 616 and second cleaning module 618 can be freely selected from any cleaning modules as long as the first cleaning module and the second cleaning module can clean the laminated wafer. In this embodiment, as the first cleaning module 616, a substrate cleaning apparatus is used, which scrub-cleans the laminated wafer by scrubbing a roll sponge on the front and back surfaces of the laminated wafer in the presence of a cleaning liquid, such as a chemical liquid, or pure water. Furthermore, as the second cleaning module 618, a substrate cleaning apparatus is used, which cleans the substrate using a pen-shaped sponge (pen sponge) in the presence of a cleaning liquid, such as a chemical liquid, or pure water.

In one embodiment, as the second cleaning module 618, a substrate cleaning apparatus may be used, which scrub-cleans the laminated wafer by scrubbing a roll sponge on both the front and back surfaces of the laminated wafer in the presence of a chemical liquid. Further, as the first cleaning module 616 or the second cleaning module 618, a substrate cleaning apparatus may be used, which injects a two-fluid jet onto the front surface (or back surface) of the laminated wafer to thereby clean the front surface (or back surface) of the laminated wafer, and together to press a roll sponge against the back surface (or front surface) of the laminated wafer to scrub-clean the back surface (or front surface) of the laminated wafer.

The type of drying module 620 can be freely selected from any drying module, as long as the drying module can dry the cleaned laminated wafer. In this embodiment, as the drying module 620, a spin-drying device is used, which holds the laminated wafer and sprays IPA vapor from a moving nozzle to dry the laminated wafer, and further dries the laminated wafer by rotating the laminated wafer at a high speed.

The first substrate transfer robot 103 receives a laminated wafer before processing from the wafer cassette placed in the front loading unit 102 and transfers the laminated wafer to the substrate transfer module 200, and also receives a dried laminated wafer from the drying module 620 and returns the laminated wafer to the wafer cassette. The substrate transfer module 200 transports the substrate received from the first substrate transfer robot 103 so as to transfer the substrate between each of the processing modules 300, 400, and 500.

In this embodiment, the first processing module 300 is a filler-application module for applying and curing a filler for protecting a knife-edge portion formed in a peripheral portion of a second wafer when the laminated substrate, in which a first wafer is bonded to a second wafer, has been thinned. Hereinafter, the first processing module 300 is referred to as the filler-application module 300, and further the knife-edge portion and configuration of the filler-application module 300 will be described in detail.

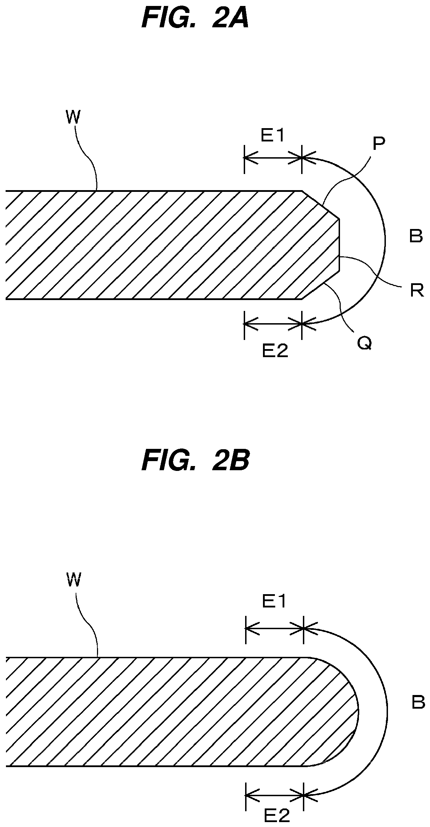

FIGS. 2A and 2B are enlarged cross-sectional views each showing a peripheral portion of a wafer which is an example of a substrate. More specifically, FIG. 2A is a cross sectional view of a wafer of a so-called straight type, and FIG. 2B is a cross sectional view of a wafer of a so-called round type. In a wafer W shown in FIG. 2A, a bevel portion is an outermost circumferential surface (indicated by symbol B) including an upper slope (or an upper bevel portion) P, a lower slope (or a lower bevel portion) Q, and a side portion (or an apex) R of the wafer W.

In a wafer W shown in FIG. 2B, a bevel portion is a portion B constituting an outermost circumferential surface of the wafer W and having a curved cross section. A top edge portion E1 is a flat portion located radially inwardly of the bevel portion B and located radially outwardly of a region D where devices are formed. A bottom edge portion E2 is a flat portion located radially inwardly of the bevel portion B and located at an opposite side from the top edge portion E1. The top edge portion E1 and the bottom edge portion E2 may be collectively referred to as a near edge portion.

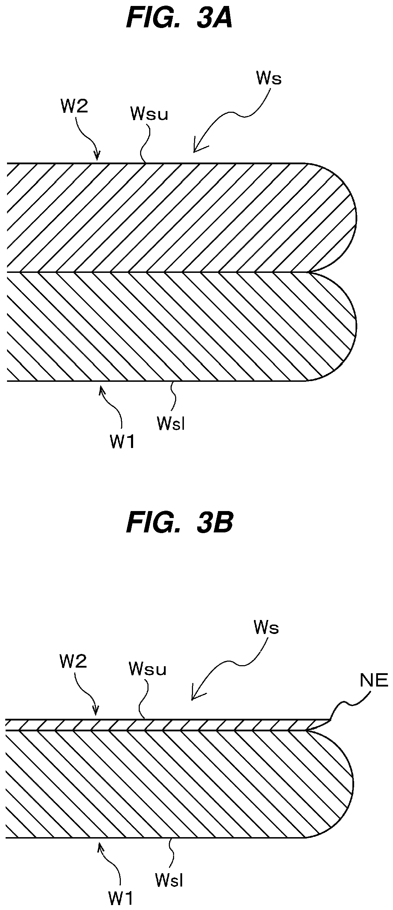

FIG. 3A is a schematic view showing an example of a laminated substrate in which two wafers are bonded to each other, and FIG. 3B is a schematic view showing the laminated substrate after the second wafer shown in FIG. 3A has been thinned. The laminated substrate Ws shown in FIG. 3A is manufactured by bonding a first wafer W1 and a second wafer W2 of the round type shown in FIG. 2B to each other.

As shown in FIG. 3B, when the second wafer W2 is thinned, a knife-edge portion NE is formed in a peripheral portion of the second wafer W2. This knife-edge portion NE is likely to be chipped by physical contact, and may cause the laminated substrate Ws to be cracked or chipped during transportation of the laminated substrate Ws and during further processing of the laminated substrate Ws. Furthermore, insufficient bonding between the first wafer W1 and the second wafer W2 may cause the second wafer W2 to be cracked or chipped during a grinding process of the second wafer W2 (i.e., a thinning process). Also in a case where the laminated substrate Ws is manufactured by bonding a first wafer W1 and a second wafer W2 of the square type shown in FIG. 2A to each other, a knife-edge portion is formed in the peripheral portion of the second wafer W2 when the second wafer W2 is thinned.

Therefore, in the filler-application module 300, a filler is applied between the first wafer W1 and the second wafer W2 of the laminated substrate Ws, and then this filler is cured, thereby effectively protecting the knife-edge portion NE.

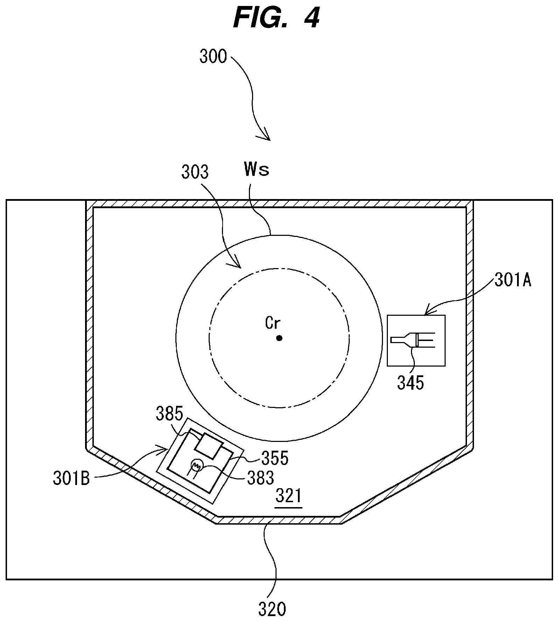

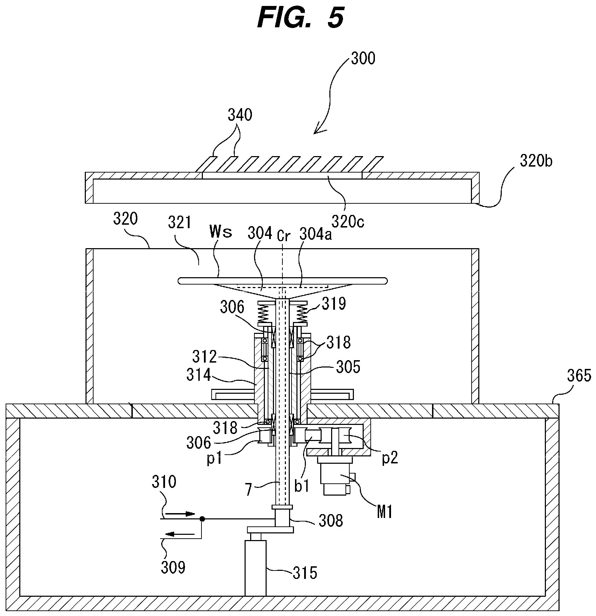

FIG. 4 is a plan view showing a filler-application module according to one embodiment, and FIG. 5 is a longitudinal cross-sectional view schematically showing the filler-application module shown in FIG. 4. The filler-application module 300 shown in FIGS. 4 and 5 is an apparatus that applies and further cures a filler to a gap formed between the wafers W1 and W2 of the laminated substrate Ws. In FIG. 5, illustrations of an application module 301A and a curing module 301B, which will be described below, are omitted.

As shown in FIGS. 4 and 5, this filler-application module 300 includes a rotary-holding mechanism (a substrate holder) 303 configured to horizontally hold a laminated substrate Ws (see FIG. 3A), in which a plurality of wafers W1, W2 are laminated, and to rotate the laminated substrate Ws. FIG. 4 illustrates a state in which the rotary-holding mechanism 303 holds the laminated substrate Ws. The rotary-holding mechanism 303 has a dish-shaped holding stage 304 configured to hold a back surface of the laminated substrate Ws by a vacuum suction, a hollow shaft 305 coupled to a central portion of the holding stage 304, and a motor M1 for rotating the hollow shaft 305. The laminated substrate Ws is placed onto the holding stage 304 by hands (not shown) of the substrate transfer mechanism 200 (see FIG. 1) such that a center of the laminated substrate Ws is aligned with a central axis of the hollow shaft 305.

The hollow shaft 305 is supported by ball spline bearings (i.e., linear motion bearings) 6 which allow the hollow shaft 5 to move vertically. The holding stage 304 has an upper surface having grooves 304a. These grooves 304a communicate with a communication passage 307 extending through the hollow shaft 305. The communication passage 307 is coupled to a vacuum line 309 via a rotary joint 308 provided on a lower end of the hollow shaft 305. The communication passage 307 is also coupled to a nitrogen-gas supply line 310 for use in releasing the laminated substrate Ws from the holding stage 304 after processing. By selectively coupling the vacuum line 309 and the nitrogen-gas supply line 310 to the communication passage 307, the laminated substrate Ws can be held on the upper surface of the holding stage 304 by the vacuum suction and can be released from the upper surface of the holding stage 304.

A pulley p1 is coupled to the hollow shaft 305, and a pulley p2 is mounted on a rotational shaft of the motor M1. The hollow shaft 305 is rotated by the motor M 1 through the pulley p1, the pulley p2, and a belt b1 riding on these pulleys p1 and p2. With these structures, the laminated substrate Ws, held on the upper surface of the holding stage 304, is rotated by the motor M1.

The ball spline bearing 306 is a bearing that allows the hollow shaft 305 to move freely in its longitudinal direction. The ball spline bearings 306 are secured to a cylindrical casing 312. Therefore, in this embodiment, the hollow shaft 305 can move linearly up and down relative to the casing 312, and the hollow shaft 305 and the casing 312 rotate in unison. The hollow shaft 305 is coupled to an air cylinder (elevating mechanism) 315, so that the hollow shaft 305 and the holding stage 304 are elevated and lowered by the air cylinder 315.

A cylindrical casing 314 is provided so as to surround the casing 312 in a coaxial arrangement. Radial bearings 318 are provided between the casing 312 and the cylindrical casing 314, so that the casing 312 is rotatably supported by the radial bearings 318. With these structures, the rotary-holding mechanism 303 can rotate the laminated substrate Ws about its central axis Cr, and can elevate and lower the laminated substrate Ws along the central axis Cr.

As shown in FIG. 4, the filler-application module 300 includes an application module (application section) 301A, and a curing module (cure section) 301B, which are placed around the laminated substrate Ws held by the rotary-holding mechanism 303. The curing unit 301B is located downstream of the application unit 301A in a direction of rotation of the laminated substrate Ws.

The application unit 301A is a device for applying a filler to a gap formed between the peripheral portion of the first wafer W1 and the peripheral portion of the second wafer W2. The curing unit 301B is a device for curing the filler supplied to the laminated substrate Ws by the application unit 301A. In this embodiment, the filler is a filler having thermosetting property. Examples of such filler may include a thermosetting resin.

The application unit 301A and the curing unit 301B are disposed in a processing chamber 321, which is partitioned by a partition 320, and thus the processing chamber 321 is isolated from outer environment by the partition 320. The application unit 301A, the curing unit 301B, and the holding stage 304 are located in the processing chamber 321. More specifically, the laminated substrate Ws during processing is housed in the processing chamber 321.

In order to isolate mechanical devices, such as the ball spline bearings 306 and the radial bearings 318, from the processing chamber 321 when the hollow shaft 305 is elevated and lowered relative to the casing 312, the hollow shaft 305 and an upper end of the casing 312 are coupled to each other by a bellows 319 that is extensible and contractible in a vertical direction, as shown in FIG. 5. FIG. 5 illustrates a state in which the hollow shaft 305 is in a lowered position and the holding stage 304 is in a processing position. After the application process and the cure process of the filler, the air cylinder 315 elevates the laminated substrate Ws together with the holding stage 304 and the hollow shaft 305 to a transport position, where the laminated substrate Ws is released from the holding stage 304.

The partition 320 has an entrance 320b through which the laminated substrate Ws is transported into and removed from the processing chamber 321. The entrance 320b is a horizontally extending cutout. Therefore, the laminated substrate Ws, held by the hands of the substrate transfer mechanism 200, can travel horizontally across the processing chamber 321 through the entrance 320b. An upper surface of the partition 320 has an aperture 320c and louvers 340, and a lower surface of the partition 320 has a gas-discharge opening (not shown). During the application process and the cure process of the filler, the entrance 320b is closed by a non-illustrated shutter. Therefore, as a fan mechanism (not shown) is driven to evacuate an air through the gas-discharge opening, downward flow of clean air is formed in the processing chamber 321. The fan mechanism serves as a pressure regulator for maintaining a pressure in the processing chamber 321 at positive pressure. Since the laminated substrate Ws ise processed in this state, the processing of the laminated substrate Ws can be performed while an upper space of the processing chamber 321 is kept clean.

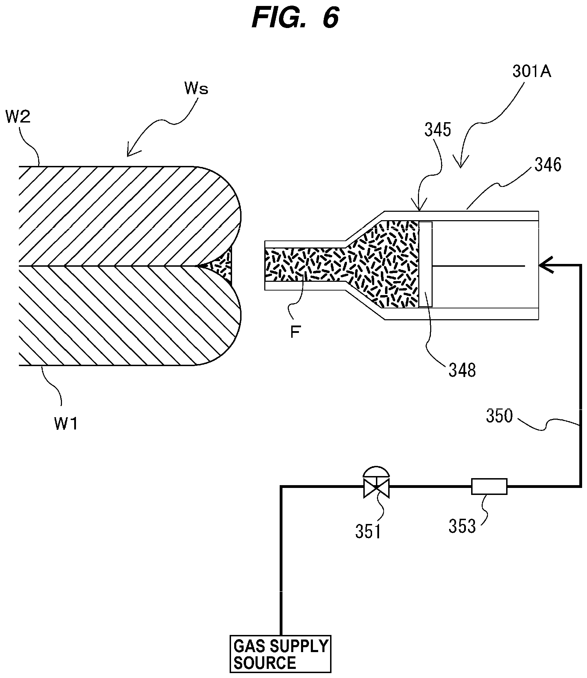

FIG. 6 is a schematic view showing an application module according to one embodiment. The application unit 301A shown in FIG. 6 has a syringe mechanism 345 for injecting a filler into a gap between the first wafer W1 and the second wafer W2, and a horizontal movement mechanism (not shown) for moving the syringe mechanism 345 so as to be approached to or separated from the laminated substrate Ws. In one embodiment, the horizontal movement mechanism may be omitted. In this case, a position of the syringe mechanism 345 relative to the holding stage 304 is determined in advance such that the filler can be properly injected into the gap between the first wafer W1 and the second wafer W2.

The syringe mechanism 345 has a syringe body 346 having a hollow structure, and a piston 348 movable reciprocally within the syringe body 346. The syringe body 346 is coupled to a gas supply source through a gas supply line 350. Supplying of gas (e.g., dry air or nitrogen gas) into the syringe body 346 from the gas supply source causes the piston 348 to be moved forward in the syringe body 346. The syringe body 346 has a tip opening opposite to the gap between the peripheral portion of the first wafer W1 and the peripheral portion of the second wafer W2. The syringe body 346 is filled with the filler F in advance, and the forward movement of the piston 348 causes the filler F to be injected from the tip opening of the syringe body 346 into the gap between the peripheral portion of the first wafer W1 and the peripheral portion of the second wafer W2.

A pressure regulator (e.g., pressure reducing valve) 351 and a flow regulator (e.g., mass flow controller) 353 are disposed in the gas supply line 350. A pressure and a flow rate of the gas supplied from the gas supply source into the syringe body 346 can be regulated to thereby control a flow rate of the filler F to be discharged from the syringe body 346.

In applying the filler F to the gap between the first wafer W1 and the second wafer W2, the holding stage 304 holding the laminated substrate Ws is first rotated at a predetermined rotation speed. Next, the syringe mechanism 345 is brought into approach to the laminated substrate Ws, and further, the gas is supplied into the syringe body 346 from the gas supply source. These operations cause the filler F to be injected into the gap between the peripheral portion of the first wafer W1 and the peripheral portion of the second wafer W2 in the rotating laminated substrate Ws.

If an amount of the filler F injected from the syringe mechanism 45 into the gap between the peripheral portion of the first wafer W1 and the peripheral portion of the second wafer W2 is too much, the filler F overflowing from the gap may contaminate an upper surface and a lower surface of the laminated substrate Ws. If an amount of the filler F injected from the syringe mechanism 45 into the gap between the peripheral portion of the first wafer W1 and the peripheral portion of the second wafer W2 is too little, there is a risk of not being able to apply a sufficient amount of the filler F to the gap. Therefore, in this embodiment, the flow rate of the filler F discharged from the syringe body 46 and the rotation speed of the holding stage 304 are controlled in advance such that a necessary and sufficient amount of filler F is supplied into the gap between the peripheral portion of the first wafer W1 and the peripheral portion of the second wafer W2 in the rotating laminated substrate Ws.

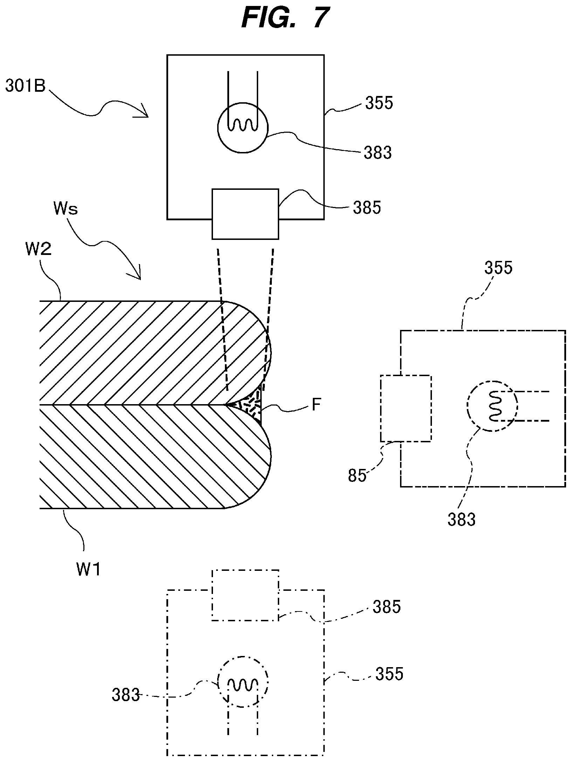

FIG. 7 is a schematic view showing a curing module according to one embodiment. The curing unit 301B shown in FIG. 7 is configured as a light-heating module having a lamp heater 355. The lamp heater 355 includes a lamp 383, and an optical device 385 that directs heat (radiant heat) from the lamp 383 to the filler F applied to the gap between the first wafer W1 and the second wafer W2. Although not shown in drawings, the optical device 385 is, for example, constituted of mirrors and/or lenses.

The lamp heater 355 shown in FIG. 7 is disposed above the second wafer W2 of the laminated substrate Ws, and the lamp 383 irradiates light having a wavelength of 1 µm or more from above the laminated substrate Ws through the optical device 385. When the lamp 383 irradiates light having a wavelength of 1 µm or more, the light irradiated from the lamp 383 transmits through the second wafer W2, enabling the filler F applied to the gap between the peripheral portion of the first wafer W1 and the peripheral portion of the second wafer W2 to be heated directly. The light-heating module having the lamp 383 has high thermal efficiency, and thus can heat and cure the filler F in a short period of time. Therefore, throughput of the filler-application module 300 can be increased.

A position of the lamp heater 355 with respect to the laminated substrate Ws can be freely selected. For example, as shown by a single-dotted line in FIG. 7, the lamp heater 355 may be disposed below the first wafer W1. In this case, the light irradiated from the lamp 383 transmits through the first wafer W1, and directly heats the filler F. Alternatively, the lamp heater 355 may be disposed such that the lamp 383 is opposite to the gap between the peripheral portion of the first wafer W1 and the peripheral portion of the second wafer W2, as shown by a double-dotted line in FIG. 7. In this case, the lamp 383 heats the filler F from a lateral side of the laminated substrate Ws. Therefore, any lamp can be used as the lamp 383 because the light irradiated from the lamp 383 is not necessary to transmit through the first wafer W1 or the second wafer W2.

In the filler-application module 300 configured in this manner, the laminated substrate Ws is first held to the holding stage 304 of the rotary-holding mechanism 303 by vacuum suction. Next, the laminated substrate Ws is rotated together with the holding stage 304. Next, the application unit 301A applies the filler F into the gap between the peripheral portion of the first wafer W1 and the peripheral portion of the second wafer W2 of the laminated substrate Ws, and then the curing unit 301B cures the applied filler F. The application process and the cure process of the filler F are continuously performed in the same processing chamber 321. Therefore, processes of the substrate for suppressing cracking and chipping of the laminated substrate Ws can be performed in a greatly short period of time.

Configuration of the application unit 301A is freely selected, as long as the application unit can apply the filler F into the gap between the peripheral portion of the first wafer W1 and the peripheral portion of the second wafer W2 of the laminated wafer Ws. For example, the application unit 301A has, instead of the syringe mechanism 45, an injection mechanism 360 that injects the filler F into the gap between the peripheral portion of the first wafer and the peripheral portion of the second wafer in the laminated substrate Ws. In this case, the injection mechanism includes an injector having an injection port opposite to the gap between the peripheral portion of the first wafer and the peripheral portion of the second wafer in the laminated substrate Ws. The injection mechanism continuously injects, by means of a pressurized fluid (e.g., pressurized air) supplied to the injector, the filler F into the gap between the peripheral portion of the first wafer W1 and the peripheral portion of the second wafer W2.

Configuration of the curing unit 301B also is freely selected, as long as the curing unit can cure the filler F applied into the gap between the peripheral portion of the first wafer W1 and the peripheral portion of the second wafer W2 of the laminated wafer Ws. For example, the curing unit 301B may be a heat-gun that blows heated gas toward the gap between the peripheral portion of the first wafer and the peripheral portion of the second wafer of the laminated wafer Ws.

Type of the filler F also is freely selected, as long as the filler can be applied into the gap between the periphery of the first wafer W1 and the periphery of the second wafer W2, and can be cured in a short period of time. For example, the filler F may be a light-curable resin.

The laminated wafer Ws, to which the filler F has been applied and cured in the filler-application module 300, are transported out of the filler-application module 300 by the substrate transfer module 200. The laminated wafer Ws is then transferred to the second processing module 400. In this embodiment, the second processing module 400 is a module that performs a back-grinding process to thin the second wafer W2 of the laminated wafer Ws. The back-grinding process can be performed with a known and appropriate apparatus. Hereinafter, the second processing module 400 is referred to as the back-grinding module 400.

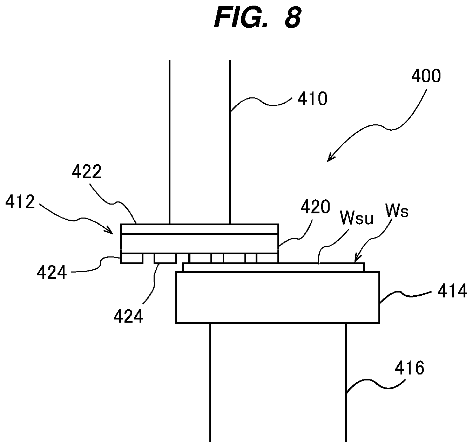

FIG. 8 is a schematic view showing a back-grinding module according to one embodiment. In the back-grinding module 400 shown in FIG. 8, the entire upper surface Wsu (see FIG. 3A) of the laminated wafer Ws, which is a back surface of the second wafer W2, is ground in order to thin the laminated wafer Ws to a predetermined thickness.

The back-grinding module 400 shown in FIG. 8 has a spindle 410 rotated by a motor not shown, a grinding head 412 secured to a tip of the spindle 410, a spindle up-and-down movement mechanism (not shown) for moving the spindle 410 up and down, a grinding table 414 on which the laminated wafer Ws are placed, and a table shaft 416 secured to the grinding table 414. Further, the back-grinding module 400 has a motor (not shown) that rotates the spindle 410, and a motor (not shown) that rotates the table shaft 416.

The grinding head 412 shown in FIG. 8 is composed of a grinding wheel 420 having a plurality of grinding wheels 424 and a wheel mount 422 to which the grinding wheel 420 can be detachably mounted. The wheel mount 422 is secured to the tip of the spindle 410. Therefore, when the spindle 410 is rotated, the entire grinding head 412 is rotated.

The laminated wafer Ws, to which the filler F has been applied and cured in the filler-application module 300, is transported out of the filler-application module 300 by hands of the substrate transfer module 200, and is placed on the grinding table 414 of the back-grinding module 400. In this process, the hands of the substrate transfer module 200 transfers the laminated wafer Ws to the back-grinding module 400 so as to align a center axis of the laminated wafer Ws with a center axis of the grinding table 414. The laminated wafer Ws placed on the grinding table 414 is held on the grinding table 414, for example, by vacuum suction.

Next, the grinding table 414 is rotated at a predetermined speed, and also the spindle 410 (i.e., the grinding head 412) is rotated at a predetermined speed. Further, the spindle up-and-down movement mechanism not shown is operated to press the grinding wheel 424 of the grinding head 412 against the upper surface Wsu of the laminated wafer Ws. Further, the spindle up-and-down movement mechanism is operated to feed the grinding head 412 downward at a predetermined grinding speed, thereby grinding the laminated wafer Ws to a predetermined thickness.

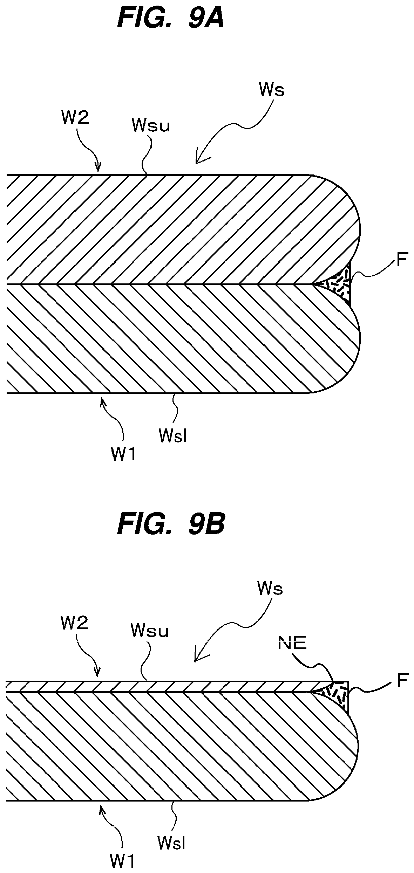

FIG. 9A is a schematic view showing the laminated wafer transported out of the filler-application module, and FIG. 9B is a schematic view showing a state where the second wafer of the laminated wafer shown in FIG. 9A is thinned in the back-grinding module.

As shown in FIG. 9B, even when the second wafer W2 is made thinner, the knife-edge portion NE formed in the peripheral portion of the second wafer W2 is protected by the filler F cured in the gap between the peripheral portion of the first wafer W1 and the peripheral portion of the second wafer W2. As a result, cracking and chipping of the laminated wafer Ws can be suppressed. Further, as shown in FIG. 9A, the peripheral portion of the first wafer W1 and the peripheral portion of the second wafer W2 are supported by each other through the cured filler F. As a result, strength of the laminated wafer Ws is increased, and thus cracking and chipping of the laminated wafer Ws can be effectively suppressed when the second wafer W2 is made thinner.

If flatness of the upper surface Wsu of the laminated wafer Ws (thinned surface of the second wafer W2) is poor after the upper surface Wsu of the laminated wafer Ws has been thinned in the back-grinding module 400, reliability of post-process, such as dicing process, may be decreased, and thus manufactured device may not perform desired performances. Therefore, in this embodiment, the third processing module 500 performs a polishing process to the upper surface Wsu of the laminated wafer Ws. The polishing process can be performed with a known and appropriate apparatus. Hereinafter, the third processing module 500 is referred to as the polishing module 500.

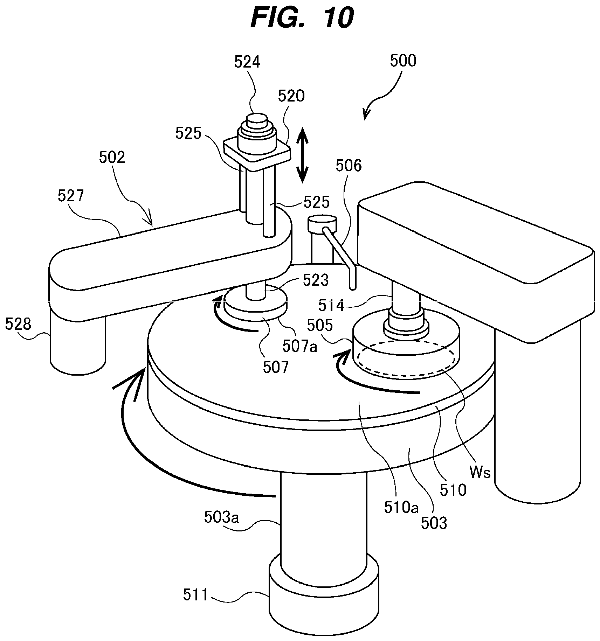

FIG. 10 is a schematic view showing a polishing module according to one embodiment. The polishing module 500 shown in FIG. 10 is a polishing apparatus that performs chemical mechanical polishing (CMP) on the entire upper surface Wsu (see FIG. 9B) of the laminated wafer Ws in order to improve the flatness of the upper surface Wsu of the laminated wafer Ws. The chemical mechanical polishing is a process of polishing a substrate by bringing the substrate into sliding contact with a polishing pad while supplying a polishing liquid containing abrasive grains, such as silica (SiO₂), onto the polishing pad.

As shown in FIG. 10, the polishing module 500 includes a polishing table 503 to which a polishing pad 501 having a polishing surface 510a is attached, a polishing head 505 for holding the laminated wafer Ws, and pressing the laminated wafer Ws against the polishing pad 510 on the polishing table 503, a polishing-liquid supply nozzle 506 for supplying a polishing liquid and a dressing liquid (e.g., pure water) onto the polishing pad 510, and a dressing apparatus 502 having a dresser 507 for dressing the polishing surface 510a of the polishing pad 510.

The polishing table 503 is coupled to a table motor 511 through a table shaft 503a, so that the polishing table 503 is rotated by this table motor 511 in a direction indicated by arrow. The table motor 511 is located below the polishing table 503. The polishing pad 510 is attached to an upper surface of the polishing table 503. The polishing pad 510 has an upper surface, which provides a polishing surface 510a for polishing the wafer. The polishing head 505 is coupled to a lower end of a head shaft 514. The polishing head 505 is configured to be able to hold the laminated wafer Ws on its lower surface by vacuum suction. The head shaft 36 is elevated and lowered by an elevating mechanism (not shown).

Polishing of the laminated wafer Ws is performed as follows. The polishing head 505 and the polishing table 503 are rotated in directions indicated by arrows, while the polishing liquid (or slurry) is supplied from the polishing-liquid supply nozzle 506 onto the polishing pad 510. In this state, the polishing head 505 presses the wafer W against the polishing surface 510a of the polishing pad 510. The surface of the laminated wafer Ws is polished by a mechanical action of abrasive grains contained in the polishing liquid and a chemical action of the polishing liquid. After polishing of the laminated wafer Ws, dressing (or conditioning) of the polishing surface 510a is performed by the dresser 507.

The dressing apparatus 502 includes a dresser 507 which is brought into sliding contact with the polishing pad 510, a dresser shaft 523 to which the dresser 507 is coupled, a pneumatic cylinder 524 mounted to an upper end of the dresser shaft 523, and a dresser arm 527 for rotatably supporting the dresser shaft 523. A lower surface of the dresser 507 serves as a dressing surface 507a, and this dressing surface 507a is formed by abrasive grains (e.g., diamond particles). The pneumatic cylinder 524 is disposed on a support base 520 which is supported by a plurality of columns 525, and these columns 525 are fixedly mounted to the dresser arm 527.

The dresser arm 527 is actuated by a motor (not shown) to pivot on a dresser pivot shaft 528. The dresser shaft 523 is rotated about its own axis by an actuation of a motor (not shown), thus rotating the dresser 7 about the dresser shaft 523 in a direction indicated by arrow. The pneumatic cylinder 524 serves as an actuator for moving the dresser 507 vertically through the dresser shaft 523 and for pressing the dresser 507 against the polishing surface (surface) 510a of the polishing pad 510 at a predetermined force.

Dressing of the polishing pad 510 is performed as follows. The pure water is supplied from the polishing-liquid supplying nozzle 506 onto the polishing pad 510, while the dresser 507 is rotated about the dresser shaft 523. In this state, the dresser 507 is pressed against the polishing pad 510 by the pneumatic cylinder 524 to place the dressing surface 507a in sliding contact with the polishing surface 510a of the polishing pad 510. Further, the dresser arm 527 pivots around the dresser pivot shaft 528 to cause the dresser 507 to oscillate in a radial direction of the polishing pad 510. In this manner, the dresser 507 scrapes slightly the polishing pad 510 to thereby dress (or restore) the surface 510a of the polishing pad 510.

In this embodiment, it is necessary to invert the upper and lower surfaces of the laminated wafer Ws in order to perform CMP processing of the laminated wafer Ws in the polishing module 500. Therefore, hands of the substrate transfer module 200 are configured to be rotatable about an center axis thereof. The laminated wafer Ws is inverted by the hands of the substrate transfer module 200 while being transferred from the back-grinding module 400 to the polishing module 500.

The laminated wafer Ws transferred to the polishing module 500 is held by the polishing head 503, and then the upper surface Wsu of the laminated wafer Ws is pressed against the polishing surface 510a of the rotating polishing pad 510, so that the entire upper surface Wsu of the laminated wafer Ws is polished.

The laminated wafer Ws polished in the polishing module 500 is cleaned in the first cleaning module 616 and/or the second cleaning module 618, and then dried in the drying module 620. The laminated wafer Ws dried in the drying module 620 is returned to the wafer cassette placed in the front loading unit 102 of the loading-and-unloading section 101 by the first transfer robot 103.

According to this embodiment, the flatness of the upper surface Wsu of the thinned laminated wafer Ws can be increased because polishing process of the upper surface Wsu of the thinned laminated wafer Ws is performed. As a result, the reliability of post-processing, such as dicing process, is improved, preventing failures in the manufactured device from occurring. Further, the application process and the curing process of the filler F to the laminated wafer Ws, the back-grinding process of the laminated wafer Ws, and the polishing process of the upper surface Wsu of the laminated wafer Ws can be all completed in one substrate processing apparatus. As a result, the time required to process the laminated wafer Ws, i.e., the time required to manufacture the devices, can be decreased.

In one embodiment, the laminated wafer Ws may be transferred to the first cleaning module 616 and/or the second cleaning module 618 to be cleaned while the laminated wafer Ws is transferred from the back-grinding module 400 to the polishing module 500. For example, the laminated wafer Ws is acid-cleaned in the first cleaning module 616 and/or the second cleaning module 618. In this case, the first cleaning module 616 and/or the second cleaning module 618 are configured to be capable of supplying a chemical liquid for acid-cleaning the laminated wafer Ws.

Cleaning the laminated wafer Ws can effectively prevent the polishing module 500 from being contaminated by contaminants, such as grinding debris generated during the back-grinding process, because such contaminants are removed reliably. Further, scratching of the laminated wafer Ws due to grinding debris during the polishing process can also be effectively prevented.

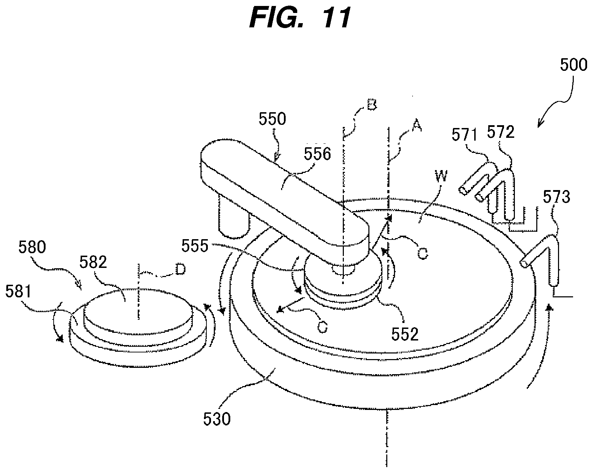

FIG. 11 is a schematic view showing the polishing module according to another embodiment. In the polishing module 500 shown in FIG. 11, the buff process of the laminated wafer Ws is performed. The buff process is a process in which a buff-process liquid is supplied onto the laminated wafer Ws, and also a contact member with a smaller diameter than the laminated wafer Ws is pressed against the laminated wafer Ws, thereby slightly polishing the upper surface Wus of the laminated wafer, or removing adhered objects from the laminated wafer Ws. The buff process can be performed using any known apparatus. In this specification, the polishing process includes the buff process. Hereinafter, an example of a buff-process apparatus will be described with reference to FIG. 11.

The polishing module 500 includes a buff table 530 on which the laminated wafer Ws is placed, a buff-process component 550, a liquid supply system 570 for supplying a buff-process liquid, and a conditioning unit 580 for conditioning (dressing) a buff pad (buff member) 552. The buff-process component 550 includes a buff head 555 to which the buff pad 552 for executing the buff process to the upper surface (processing surface) Wsu of the laminated wafer Ws is mounted, and a buff arm 556 for holding the buff head 555.

The buff-process liquid includes at least one of DIW (pure water), a cleaning chemical liquid, and a slurry. The buff pad 552 is formed of a foamed polyurethane-based hard pad, a suede-based soft pad, or a sponge, for example. The type of the buff pad 552 only needs to be selected as appropriate in accordance with a material of the upper surface Wsu of the laminated wafer W, or a state of a contaminant to be removed. Further, a groove structure, such as a concentric groove, an XY groove, a spiral groove, or a radial groove, for example, may be formed on a surface of the buff pad 552. Furthermore, at least one or more holes penetrating the buff pad 552 may be provided in the buff pad 552 so that the buff-process liquid is supplied through this hole. Moreover, a sponge-like material through which the buff-process liquid can permeate, such as a PVA sponge, may be used for the buff pad 552. These structures enable a flow distribution of the buff-process liquid in a buff-pad-surface to be uniformed, and the contaminant removed by the buff process to be rapidity discharged.

The buff table 500 has a mechanism for adsorbing the laminated wafer Ws. Further, the buff table 500 can be rotated around a rotation axis A by a driving mechanism, not shown. In one embodiment, the buff table 500 may cause the laminated wafer Ws to make a scroll motion by the driving mechanism, not shown. The buff pad 552 is opposite to the upper surface Wsu of the laminated wafer Ws placed on the buff head 555. The buff head 555 can be rotated around a rotation axis B by a driving mechanism, not shown. Further, the buff head 555 is configured to press the buff pad 552 against the upper surface Wsu of the laminated wafer Ws with a predetermined pressing force using a drive mechanism, not shown. The buff arm 556 is configured to be able to move the buff head 555 within a range of a radius or a diameter of the laminated wafer Ws as indicated by an arrow C. Moreover, the buff arm 556 is configured to be able to swing the buff head 555 to a position where the buff pad 552 is faced with the conditioning unit 580.

The conditioning unit 580 is an unit for conditioning the surface of the buff pad 552. The conditioning unit 580 includes a dress table 581, and a dresser 582 mounted to the dress table 581. The dress table 581 can be rotated around a rotation axis D by the driving mechanism, not shown. In one embodiment, the dress table 581 may be configured to cause the dresser 582 to make a scroll motion by the driving mechanism, not shown.

In conditioning of the buff pad 552, the buff arm 556 is swung until the buff pad 552 comes to a position faced with the dresser 582. The dress table 810 is then rotated around a rotation axis D, while rotating the buff head 555. Further, the buff pad 502 is pressed against the dresser 582, so that conditioning of the buff pad 552 is performed.

The liquid supply system 570 includes a pure-water nozzle 571 for supplying a pure water (DIW) onto the upper surface Wsu of the laminated wafer Ws, a chemical-liquid nozzle 572 for supplying a chemical-liquid (Chemi) onto the upper surface Wsu of the laminated wafer Ws, and a slurry nozzle 573 for supplying a slurry onto the upper surface Wsu of the laminated wafer Ws.

Buff process is performed as follows. The processing liquid is supplied onto the upper surface Wsu of the laminated wafer Ws, and further the buff table 500 is rotated around the rotation axis A to press the buff pad 552 against the upper surface Wsu of the laminated wafer Ws. At the same time, the buff head 555 is rotated around the rotation axis B, and swung in the direction of arrow C to execute the buff process to the upper surface Wsu of the laminated wafer Ws. This buff process results in slight polishing of the upper surface Wsu of the laminated wafer Ws, and in removing contaminants adhering to the upper surface Wsu of the laminated wafer Ws.

As in this embodiment, buffing the upper surface Wsu of the laminated wafer Ws can also improve the flatness of the upper surface Wsu of the laminated wafer Ws after thinning. As a result, not only the reliability of post-process, such as dicing process, can be increased, but also the time required to process the laminated wafer Ws, i.e., the time required to manufacture the devices, can be decreased.

In this embodiment, it is unnecessary to invert the laminated wafer Ws, unlike the CMP apparatus described with reference to FIG. 10. Therefore, adherence of impurities in air to the laminated wafer Ws is suppressed, as well as transfer time from the back-grinding module 400 to the polishing module 500 can be decreased.

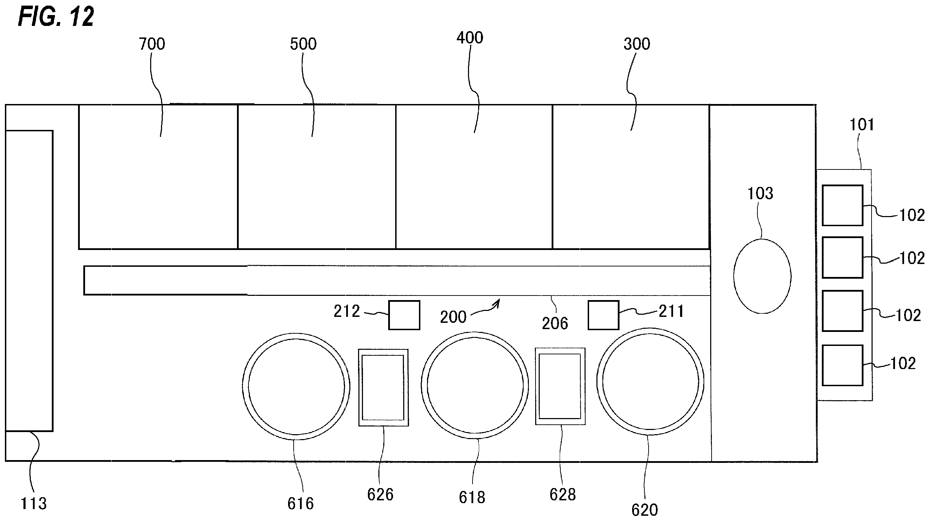

FIG. 12 is a top view schematically showing the substrate processing apparatus according to another embodiment. Configurations of this embodiment, which will not be particularly described, are the same as those of the embodiments described above, and redundant descriptions thereof will be omitted.

The substrate processing apparatus shown in FIG. 12 differs from the embodiments described above in that the substrate processing apparatus has a fourth processing module 700 in addition to the filler-application module 300, the back-grinding module 400, and the polishing module 500. In this embodiment, the fourth processing module 700 is a finish-polishing module for further polishing (additionally polishing) the laminated wafer Ws that have been polished in the polishing module 500. Hereinafter, the third processing module 500 is referred to as the first polishing module 500 and the fourth processing module 700 is referred to as the second polishing module 700.

The second polishing module 700 is a module for finish-polishing the upper surface Wsu of the laminated wafer Ws that has been polished in the first polishing module 500. Configuration of the second polishing module 700 is freely selected as long as the second polishing module can finish-polish the upper surface Wsu of the laminated wafer Ws that has been polished in the first polishing module 500. For example, while the first polishing module 500 is the CMP apparatus described with reference to FIG. 10, the second polishing module 700 may be the buffing apparatus described with reference to FIG. 11. In this case, during the transfer of the laminated wafer Ws from the first polishing module 500 to the second polishing module 700, the laminated wafer Ws is inverted by hands of the substrate transfer module 200.

Alternatively, the second polishing module 700 may be a CMP apparatus having the same configuration as the CMP apparatus described with reference to FIG. 10. In this case, the polishing pad of the second polishing module 700, for example, may have a finer polishing surface than the polishing surface 510a of the polishing pad 510 of the first polishing module 500. Further, abrasive grains of the slurry supplied onto the polishing surface of the polishing pad from the polishing-liquid supply nozzle of the second polishing module 700 may have a smaller grain size than that of the abrasive grains of the slurry supplied onto the polishing surface 510a of the polishing pad 510 from the polishing-liquid supply nozzle 506 of the first polishing module 500.

In this embodiment, after the upper surface Wsu of the laminated wafer Ws has been polished in the first polishing module 500, the laminated wafer Ws is finish-polished in the second polishing module 700. Therefore, the flatness of the upper surface Wsu of the laminated wafer Ws can be further increased, resulting in more improvement in the reliability of post-process, such as dicing process.

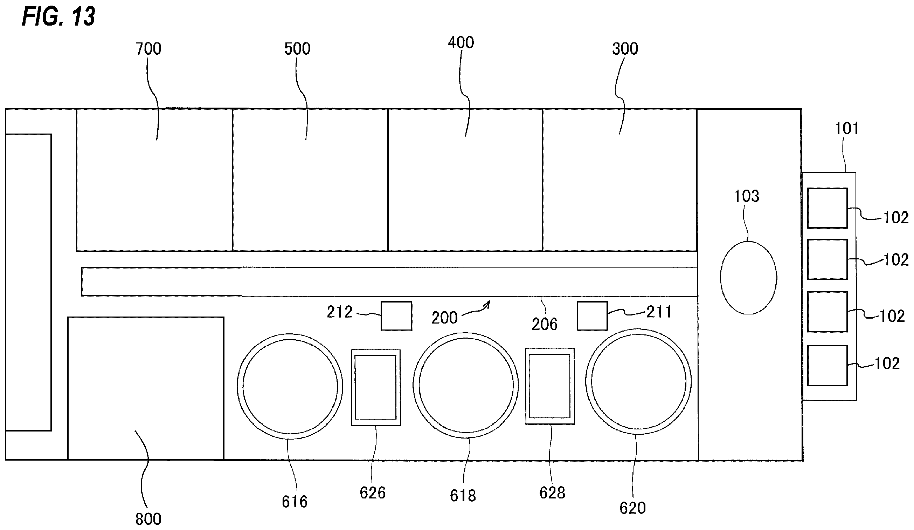

FIG. 13 is a top view schematically showing the substrate processing apparatus according to still another embodiment. Configurations of this embodiment, which will not be particularly described, are the same as those of the embodiments described above, and redundant descriptions thereof will be omitted.

The substrate processing apparatus shown in FIG. 13 differs from the embodiments described above in that the substrate processing apparatus has a fifth processing module 800 in addition to the filler-application module 300, the back-grinding module 400, and the polishing module 500. Although not shown, the fourth processing module 700 may be omitted in the substrate processing apparatus shown in FIG. 13. In this case, the upper surface Wsu of the laminated wafer Ws is polished only by the polishing module 500.

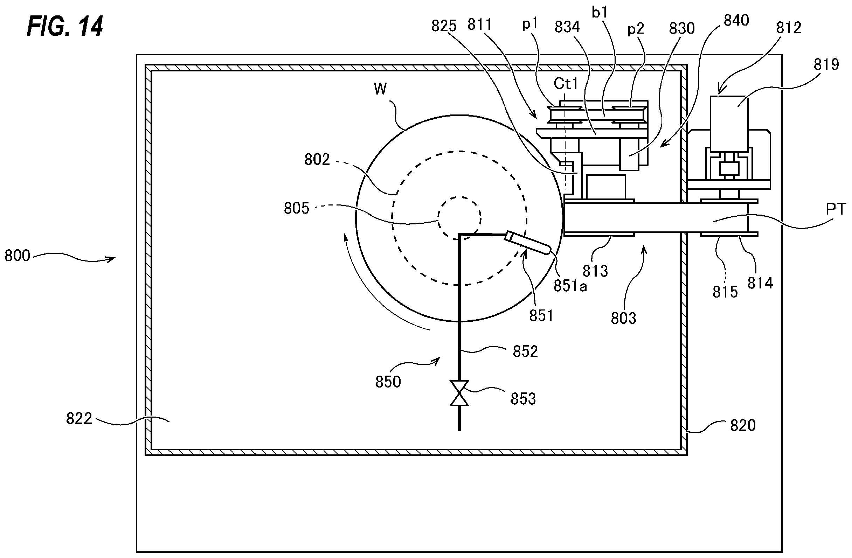

Depending on the post-process, such as dicing process, the filler F remained in the laminated wafer Ws may have an adverse effect on the devices. For example, objects detached from the filler F may damage the devices, or volatile components from the filler F may contaminate the devices. Therefore, it is preferable to remove the filler F from the laminated wafer Ws after thinning. Accordingly, the substrate processing apparatus according to this embodiment has the fifth processing module 800 that serves as a module for removing the filler F applied and cured in the gap formed between the wafers W1 and W2 of the laminated wafer Ws in the filler-application module 300. Hereinafter, the fifth processing module 800 is referred to as the filler-removal module 800. Configuration of the filler-removal module 800 is freely selected, as long as the filler-removal module can remove the filler F applied and cured in the gap formed between the wafers W1 and W2 of the laminated wafer Ws. An example of the filler-removal module will be described below with reference to FIG. 14.

FIG. 14 is a plan view schematically showing a filler-removal apparatus according to one embodiment. As shown in FIG. 14, the filler-removal apparatus 800 has a substrate holder 802 configured to hold and rotate the laminated wafer Ws horizontally, and a filler-removal unit 803 configured to press a polishing tape PT against the peripheral portion of the laminated wafer Ws to thereby remove the filler F that has cured in the gap between the peripheral portion of the first wafer W1 and the peripheral portion of the second wafer W2.

FIG. 14 illustrates a state in which the substrate holder 802 holds the laminated substrate Ws. The substrate holder 802 has a hollow shaft 805 and a motor (not shown) for rotating the hollow shaft 805. The hollow shaft 805 is supported by ball spline bearings (not shown) which allow the hollow shaft 805 to move vertically.

The filler-removal unit 803 has a polishing head assembly 811 that presses an polishing tape PT against the peripheral portion of the laminated wafer Ws to thereby remove the filler F, and a polishing-tape supply-and-recovery mechanism 812 that supplies the polishing tape PT to the polishing head assembly 811. The polishing head assembly 811 is disposed within a removal chamber 822 formed by a partition-wall 820, and the polishing-tape supply-and-recovery mechanism 812 is disposed externally of the removal chamber 822.

The polishing-tape supply-and-recovery mechanism 812 includes a supply reel 814 for supplying the polishing tape PT to the polishing head assembly 811, and a recovery reel for recovering the polishing tape PT that has been used in removal of the filler F. Please note that the recovery reel is not illustrated in FIG. 14 because the recovery reel is arranged below the supply reel 814.

A motor 819 is coupled to each of the supply reel 814 and the recovery reel. In FIG. 14, only the motor 819 coupled to the supply reel 814 is illustrated. The motors 819 exert a predetermined torque on the supply reel 814 and the recovery reel, respectively, to apply a predetermined tension to the polishing tape PT.

The polishing head assembly 811 has a polishing head 813 for bringing the polishing tape PT into contact with the peripheral portion of the laminated wafer Ws. The polishing tape PT is supplied to the polishing head 813 such that a polishing surface of the polishing tape PT is facing the laminated wafer Ws. The polishing head 813 presses the polishing tape PT against the peripheral portion of the laminated wafer Ws to remove the cured filler F.
the polishing head 813 is secured to one end of an arm 825, which is rotatable about an axis Ct1 extending parallel to a tangential direction of the laminated wafer Ws. The other end of the arm 825 is coupled to a motor 830 via pulleys p1, p2 and a belt b1. As the motor 830 rotates in a clockwise direction and a counterclockwise direction through a certain angle, the arm 825 rotates about the axis Ct1 through a certain angle. In this embodiment, the motor 830, the arm 825, the pulleys p1, p2, and the belt b1 constitute a head tilting mechanism 840 for tilting the polishing head 813 with respect to the surfaces (upper surface and lower surface) of the laminated wafer Ws.

The head tilting mechanism 840 is mounted to a movable base 834. This movable base 834 is configured to be movable linearly in a radial direction of the laminated wafer Ws. Therefore, the polishing head assembly 811 is operated so as to move closer to and away from the laminated wafer Ws along the radial direction of the laminated wafer Ws.

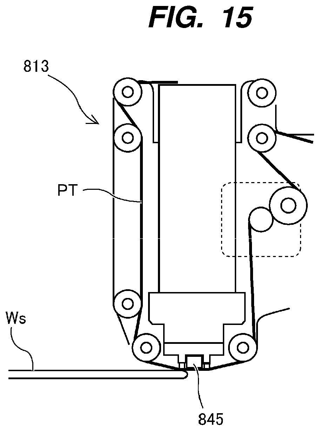

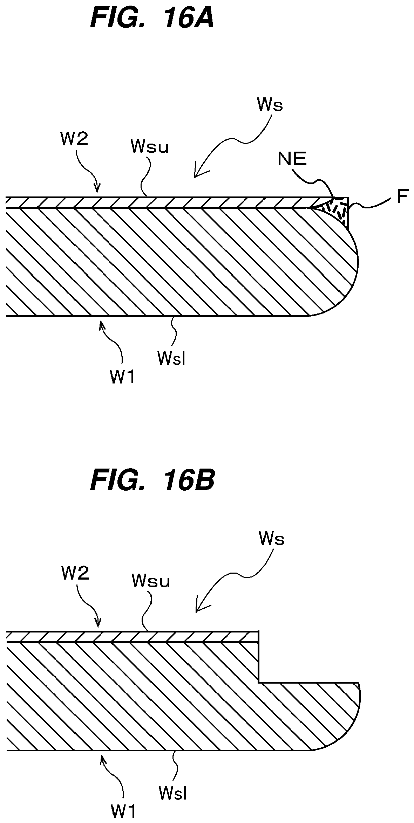

FIG. 15 is a view showing a state in which the polishing head is removing the filler. When the filler F is removed, the polishing head 813 is, as shown in FIG. 15, tilted upward to press the polishing tape PT against the upper surface Wsu of the laminated wafer Ws, removing the filler F together with the knife-edge portion NE. During the removal of the filler F, the polishing tape PT is fed at a predetermined speed. FIG. 16A is a schematic view showing a state in which the second wafer of the laminated wafer has been thinned, and FIG. 16B is a schematic view showing a state in which the filler F has been removed.

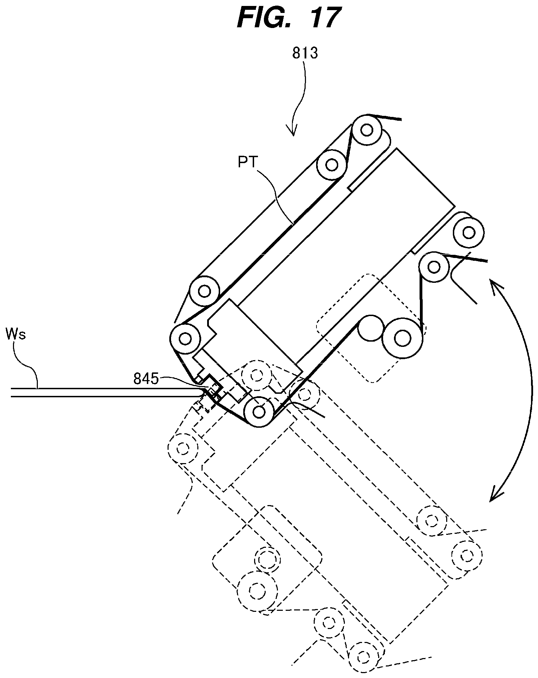

In one embodiment, after removing the filler F, the head tilting mechanism 840 described above is used to continuously change the tilt angle of the polishing head 813 while pressing the polishing tape PT against the bevel portion of the laminated wafer Ws by use of a pressure pad 845, as shown in FIG. 17. This operation can remove contaminants, such as polishing debris, from the entire bevel portion of the laminated wafer Ws.

In one embodiment, the filler-removal apparatus may include a removal-agent supply mechanism 850 for facilitating the removal of the filler F. The removal-agent supply mechanism 850 is configured to supply a removal agent of the filler to the peripheral portion of the laminated wafer Ws in order to facilitate removal of the filler F. In the embodiment shown in FIG. 14, the removal-agent supply mechanism 850 has a removal-agent nozzle 851 configured to supply the removal agent into the peripheral portion of the laminated wafer Ws, a removal-agent supply line 852 coupled to the removal-agent nozzle 851, and an open/close valve 853 mounted to the removal-agent supply line 852.

The removal-agent nozzle 851 of the removal-agent supply mechanism 850 is arranged adjacent to the laminated wafer Ws in the removal chamber 822, and is located downstream of the polishing head 813 in a direction of rotation of the laminated wafer Ws. Examples of the removal agent supplied from the removal-agent nozzle 851 include solvent, such as acetone, and toluene.

In the embodiment shown in FIG. 14, the open/close valve 853 is arranged inside the removal chamber 822. However, the open/close valve 853 may also be arranged outside the removal chamber 822. When the open/close valve 853 is opened, the removal agent is supplied into the peripheral portion of the laminated wafer Ws, so that the removal of the filler F is facilitated.

In one embodiment, the filler-removal apparatus may omit the filler removal unit 803. In this case, the filler F is removed by the removal agent supplied from the removal-agent supply mechanism 850.

In this substrate processing apparatus according to this embodiment, after the thinning process of the laminated wafer Ws is performed in the back-grinding module 400, the polishing process of the laminated wafer Ws is performed in the polishing module 500 (and the polishing module 700), and then in the filler-removal module 800, the filler F is removed from the laminated wafer Ws. In one embodiment, after the thinning process of the laminated wafer Ws is performed in the back-grinding module 400, the filler F may be removed from the laminated wafer Ws in the filler removal module 800, and then the polishing process of the laminated wafer Ws may be performed in the polishing module 500 (and the polishing module 700).

According to this embodiment, the application process and the curing processes of the filler F to the laminated wafer Ws, the back-grinding process of the laminated wafer Ws, the polishing process of the upper surface Wsu of the laminated wafer Ws, and the removal process of the filler F can be all completed in one substrate processing apparatus. As a result, the time required to process the laminated wafer Ws, i.e., the time required to manufacture the devices, can be decreased.

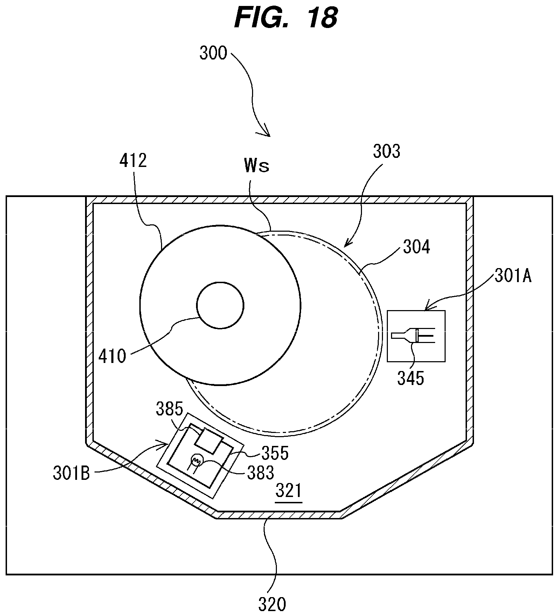

FIG. 18 is a top view schematically showing the first processing module according to another embodiment. The first processing module 300 shown in FIG. 18 has the spindle 410 of the back-grinding module 400, and the grinding head 412 secured to the end of the spindle 410, which are described with reference to FIG. 8. Configuration of the grinding head 412 in this embodiment is the same as the configuration of the grinding head 412 described with reference to FIG. 8, and redundant description thereof will be omitted.

As described above, the spindle 410 is rotated by a motor not shown, which in turn causes the grinding head 412 to be rotated. Further, operating the spindle up-and-down movement mechanism (not shown) causes the grinding head 412 to be driven downward at a predetermined grinding speed, thereby enabling the laminated wafer Ws to be ground to a predetermined thickness. Specifically, in this embodiment, the first processing module 300 can perform the application process and the curing process of the filler F to the laminated wafer Ws and the back-grinding process of the laminated wafer Ws. As a result, throughput of the substrate processing apparatus is increased. Further, a footprint of the substrate processing apparatus can be reduced because the second processing module 400 is no longer required.

In this embodiment, in order to prevent the laminated wafer Ws, which is pressed by the grinding head 412 during the back-gliding process of the laminated wafer Ws, from being bent or damaged, a diameter of the holding stage 304 of the rotary-holding mechanism 303 is preferably about the same as a diameter of the laminated wafer Ws.

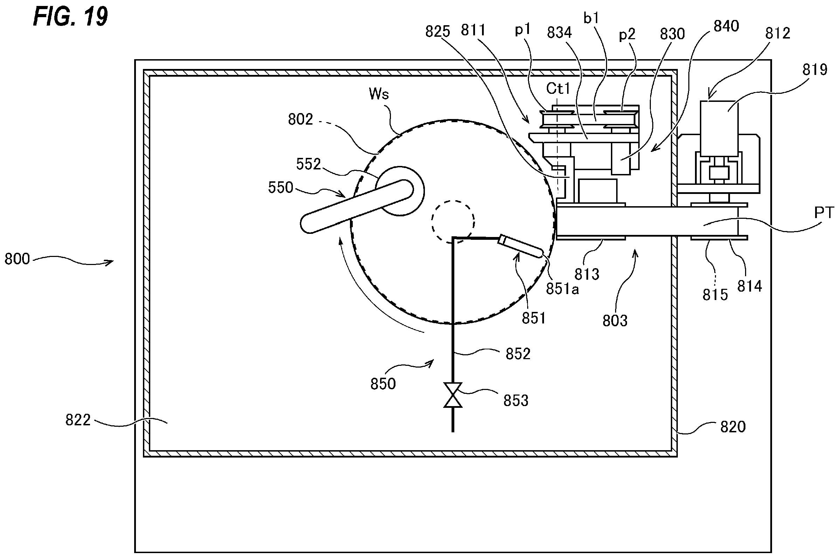

FIG. 19 is a top view schematically showing the fifth processing module according to another embodiment. The fifth processing module 800 shown in FIG. 19 has the buff-process component 550, the buff pad 552, the pure-water nozzle 571 for supplying a pure water (DIW) onto the upper surface Wsu of the laminated wafer Ws, the chemical-liquid nozzle 572 for supplying thea chemical liquid onto the upper surface Wsu of the laminated wafer Ws, and the slurry nozzle 573 for supplying the slurry onto the upper surface Wsu of the laminated wafer Ws, which are described with reference to FIG. 11. In FIG. 19, illustration of these nozzles 571, 572, and 573 is omitted. Configurations of the buff-process component 550, the buff pad 552, and the nozzles 571, 572, 573 in this embodiment are the same as those of the buff-process component 550, the buff pad 552, and the nozzles 571, 572, 573 described with reference to FIG. 8, and redundant descriptions thereof are omitted.

In this embodiment, the laminated wafer Ws that has been thinned in the back-grinding module 400 is transferred to the fifth processing module 800, and the polishing process of the upper surface Wsu of the laminated wafer Ws and the removal process of the filler F are performed in the fifth processing module 800. As described above, while supplying the processing liquid from at least one of nozzles 571, 572, and 573 onto the upper surface Wsu of the laminated wafer Ws, the buff pad 552 is pressed against the upper surface Wsu of the laminated wafer Ws, so that the upper surface Wsu of the laminated wafer Ws is slightly polished, and contaminants adhering to the upper surface Wsu of the laminated wafer Ws are removed.

Next, the polishing head 813 is tilted upward, and the polishing tape PT is pressed against the upper surface Wsu of the laminated wafer Ws to remove the filler F together with the knife-edge portion NE. In this manner, in this embodiment, the fifth processing module 800 can perform the polishing process of the laminated wafer Ws and the removal process of the filler F. As a result, throughput of the substrate processing apparatus is increased. Further, a footprint of the substrate processing apparatus can be reduced because the third processing module 500 (and the fourth processing module 700) is no longer required.

In this embodiment, in order to prevent the laminated wafer Ws, which is pressed by the buff pad 552 during the polishing process of the laminated wafer Ws, from being bent or damaged, a diameter of the substrate holder 802 is preferably about the same as a diameter of the laminated wafer Ws.

In one embodiment, the third processing module 500 (and the fourth processing module 700) may be omitted in order only to prevent objects detached from the filler F from damaging the devices, or volatile components from the filler F from contaminating the devices. In this case, after the filler is applied to the gap formed between the wafers W1 and W2 of the laminated wafer and further cured in the first processing module 300, the laminated wafer Ws is transferred to the fifth processing module 800, where the filler F is removed from the laminated wafer Ws. In this embodiment, it is effectively prevented that the objects detached from the filler F damage the devices and that volatile components from the filler F contaminate the devices.

In the embodiments described above, the substrate processing apparatus and the substrate processing method for processing the laminated substrate Ws composed of two wafers W1, W2 have been described. However, the laminated substrate Ws is not limited to these embodiments. The laminated substrate Ws may be composed of three or more wafers.

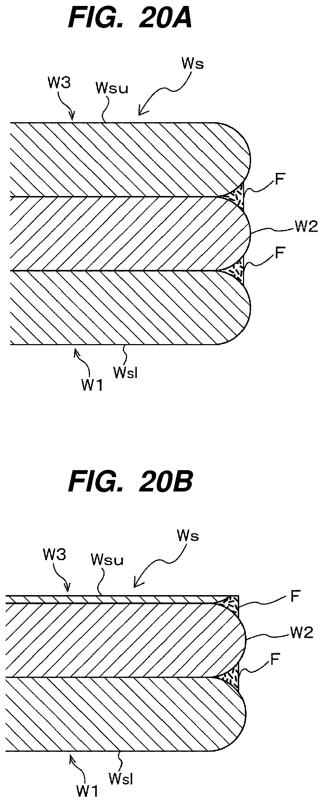

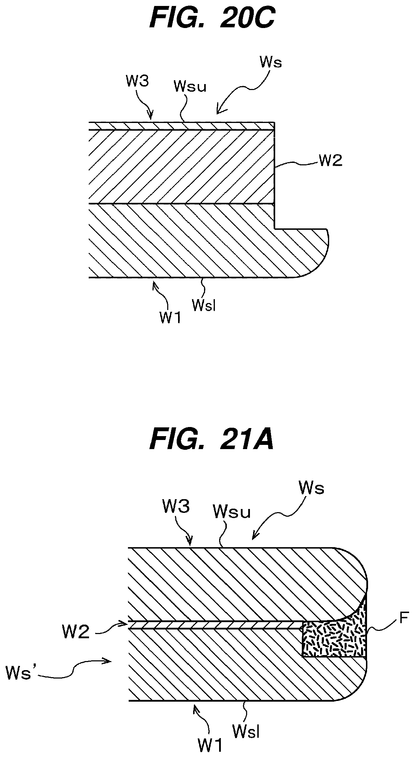

FIG. 20A is a cross-sectional view schematically showing an example of the laminated substrate Ws composed of three wafers, FIG. 20B is a cross-sectional view schematically showing a state in which the upper surface of the laminated substrate Ws shown in FIG. 20A has been ground, and FIG. 20C is a cross-sectional view showing a state in which the filler in the laminated substrate Ws shown in FIG. 20B has been removed.

As shown in FIG. 20A, in the laminated wafer Ws, of which three or more wafers W1, W2, and W3 are laminated, the filler F is applied to a gap formed between peripheral portions of adjacent wafers W1 and W2, and a gap formed between peripheral portions of adjacent wafers W2 and W3 in the filler-application module 300 described above, and is then cured.

Next, as in the embodiments described above, the laminated wafer Ws to which the filler F has been applied and cured (see FIG. 20A) has the upper surface Wsu thereof ground in the back-grinding module 400 (see FIG. 20B). Further, in the laminated substrate Ws whose upper surface Wsu has been ground, the polishing process of the upper surface Wsu is performed in the polishing module 400 and/or the polishing module 500, and then the filler F is removed in the filler removal module 800 (see Fig. 20C). In one embodiment, after the filler F is removed in the filler-removal module 800, the polishing process of the upper surface Wsu in the laminated substrate Ws whose upper surface Wsu has been ground, may be polished in the polishing module 400 and/or the polishing module 500. Even for laminated wafer Ws composed of three or more wafers as shown in FIGS. 20A to 20C, the same grinding process, the polishing process, and the filler-removal process can be performed with the substrate processing apparatus according to the embodiments described above.

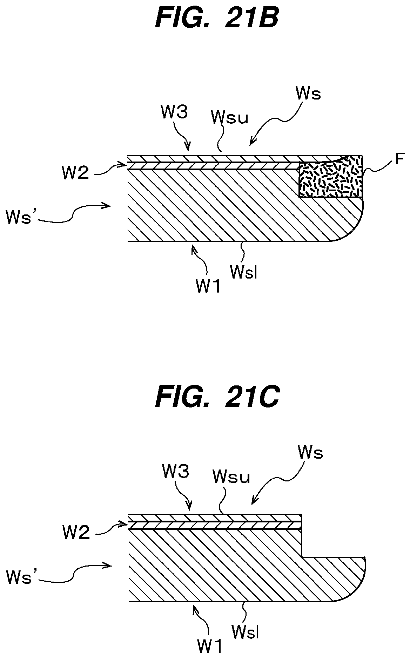

FIG. 21A is a cross-sectional view schematically showing another example of the laminated substrate composed of three wafers, FIG. 21B is a cross-sectional view schematically showing a state in which the upper surface of the laminated substrate shown in FIG. 21A is ground, and FIG. 21C is a cross-sectional view showing a state in which the filler is removed from the laminated substrate shown in FIG. 21B.

The laminated wafer Ws shown in FIG. 21A is composed of a first wafer W1, a second wafer W2, and a third wafer W3. In FIG. 21A, a combination of the first wafer W1 and the second wafer W2 is a laminated wafer Ws' in which the grinding process, the polishing process, and the filler removal process have been performed in the substrate processing apparatus according to the embodiments described above. The laminated wafer Ws' shown in FIG. 21A corresponds to the laminated wafer Ws shown in FIG. 16B. The third wafer W3 is laminated to an upper surface of the laminated wafer Ws' with another substrate processing apparatus.

As shown in FIG. 21A, in the laminated wafer Ws composed of the laminated wafer Ws' (i.e., the first wafer W1 and the second wafer W2) and the third wafer W3, the filler F is applied to a gap between peripheral portions of the laminated wafer Ws' and the third wafer W3, which are adjacent to each other, and is then cured in the filler application module 300 described above.

Next, as in the embodiments described above, the laminated wafer Ws to which the filler F has been applied and cured (see FIG. 21A) has the upper surface Wsu thereof ground in the back-grinding module 400 (see FIG. 21B). Further, in the laminated substrate Ws whose upper surface Wsu has been ground, the polishing process of the upper surface Wsu is performed in the polishing module 400 and/or the polishing module 500, and then the filler F is removed in the filler-removal module 800 (see Fig. 21C). In one embodiment, after the filler F in the laminated substrate Ws, whose upper surface Wsu has been ground, is removed in the filler-removal module 800, the polishing process of the upper surface Wsu may be performed in the polishing module 400 and/or the polishing module 500.

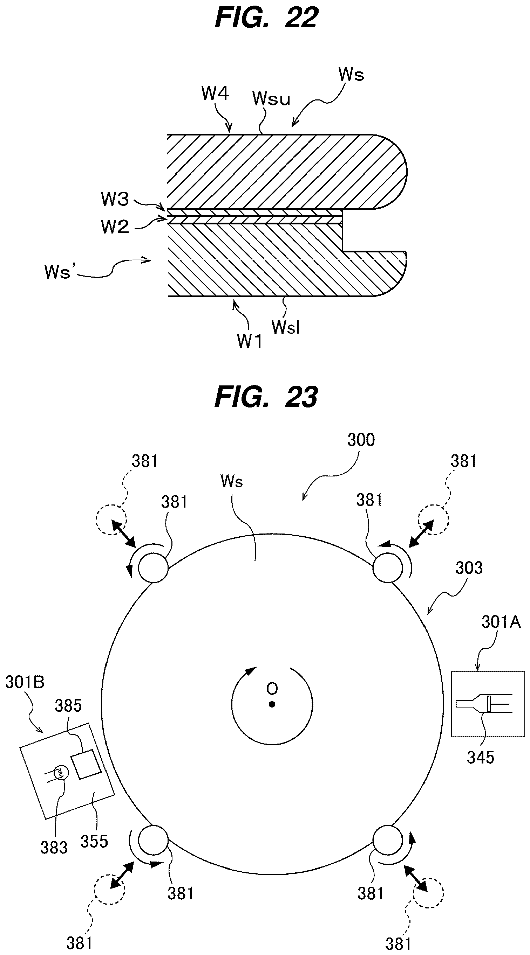

FIG. 22 is a cross-sectional view schematically showing an example of the laminated substrate composed of four wafers. The laminated wafer Ws shown in FIG. 22 is composed of a laminated wafer Ws', which is composed of a first wafer W1, a second wafer W2, and a third wafer W3, and to which the grinding process, the polishing process, and the filler-removal process are performed in the substrate processing apparatus according to the embodiments described above, and a fourth wafer W4. In this laminated wafer Ws also, the filler F is applied to a gap between peripheral portions of the laminated wafer Ws' and the fourth wafer W4, which are adjacent to each other, and then cured in the filler-application module 300. Further, the upper surface Wsu is ground in the back-grinding module 400, the polishing process of the upper surface Wsu is performed in the polishing module 400 and/or the polishing module 500, and then the filler F is removed in the filler-removal module 800. After the filler F in the laminated substrate Ws, whose upper surface Wsu has been ground, is removed in the filler-removal module 800, the polishing process of the upper surface Wsu may be performed in the polishing module 400 and/or the polishing module 500.

In this manner, there is no limitation for the number of wafers composing the laminated wafer Ws to be processed in the substrate processing apparatus according to the embodiments described above, because the grinding process, the polishing process, and the filler-removal process of the laminated wafer Ws can be performed by the substrate processing apparatus according to the embodiments described above, and further other wafers are laminated on the upper surface of the processed laminated wafer Ws (Ws'). The laminated wafer Ws may be manufactured by conveying the laminated substrate Ws processed by the substrate processing apparatus according to the embodiments described above to another apparatus and then laminating another wafer on the upper surface of the laminated substrate Ws in another apparatus, or , the laminated substrate Ws as shown in FIGS. 21A and FIG.22 may be manufactured by using one or more apparatuses different from the substrate processing apparatus according to the embodiments described above.

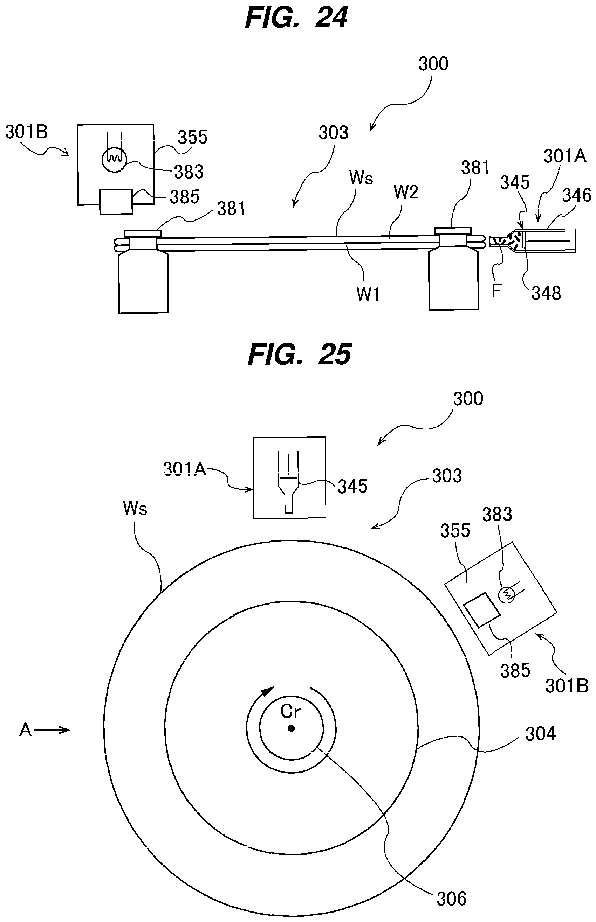

FIG. 23 is a plan view showing the filler-application module according to another embodiment. FIG. 24 is a side view of the filler-application module shown in FIG. 23. Configurations of this embodiment, which will not be particularly described, are the same as those of the embodiments described above, and redundant descriptions thereof will be omitted. In this embodiment, the rotary-holding mechanism 303 of the filler application module 300 has, instead of the holding stage 304, the hollow shaft 305, and the motor M1, three or more (four in this embodiment) rollers 381 that can be in contact with the peripheral portion of the laminated substrate Ws, a roller rotation mechanism (not shown) configured to rotate each of the rollers 381 around an axis center thereof, and a roller movement mechanism (not shown) configured to move the rollers 381, respectively. In this embodiment, the rotary-holding mechanism 303 has the four rollers 381, but the rotary-holding mechanism 303 may have three rollers 381, or five or more rollers 381.

The four rollers 381 are arranged around a reference center point O of the rotary-holding mechanism 303. The rollers 381 are configured to be capable of being in contact with the peripheral portion of the laminated substrate Ws to hold the laminated substrate Ws horizontally. More specifically, the laminated substrate Ws is held in a horizontal state by the rollers 381 of the rotary-holding mechanism 303. As shown in FIG. 23, when the laminated substrate Ws is held in a horizontal state by the rollers 381 of the rotary-holding mechanism 303, the upper surface and the lower surface of the laminated substrate Ws are in virtual planes extending in the horizontal direction, respectively.

The roller rotation mechanism is coupled to the four rollers 381, and is configured to rotate the four rollers 381 in the same direction and at the same speed. Configuration of the roller rotation mechanism is freely selected, as long as the roller rotation mechanism can rotate three or more rollers 381 in the same direction and at the same speed, and any known rotation mechanism can be used as the roller rotation mechanism. Examples of the roller rotation mechanism may include a combination of motor, pulley (and/or gear), and rotation belt.

The roller movement mechanism is coupled to the four rollers 381, and is configured to be capable of moving each of the rollers 381 in a direction approaching toward and away from the reference center point O of the rotary-holding mechanism 303. The roller movement mechanism enables the four rollers 381 to be moved between a hold position (see a solid line in FIG. 23), where the peripheral portion of the laminated substrate Ws is held by the rollers 381, and a release position (see a dotted line in FIG. 23), where the laminated substrate Ws is released from the rollers 381.

Configuration of the roller movement mechanism is freely selected, as long as the four rollers 381 can be moved between the hold position and the release position, and any known movement mechanism can be used as the roller movement mechanism. Examples of the roller movement mechanism may include a piston-cylinder mechanism, and a combination of ball screw and motor (i.e., stepping motor).

The roller rotation mechanism and the roller movement mechanism of the rotary-holding mechanism 303 are electrically coupled to the controller 113 (see FIG. 1) described above. The controller 113 is configured to be able to control operations of the roller rotation mechanism and the roller movement mechanism of the rotary-holding mechanism 303.

The laminated substrate Ws is transferred by a transfer device, not shown, to a position where an axis center of the laminated substrate Ws is aligned with the reference center point O of the rotary-holding mechanism 303. At this time, the rollers 381 are in the release position. Next, the roller movement mechanism moves the four rollers 381 to the hold position, so that the peripheral portion of the laminated substrate Ws is held by the four rollers 381. This operation causes the laminated substrate Ws to be held in a horizontal state by the four rollers 381. Rotating the four rollers 381, moved to the hold position, by use of the roller rotation mechanism causes the laminated substrate Ws to be rotated around the axis center thereof.

When the four rollers 381 in the hold position are moved to the release position by the roller movement mechanism, the four rollers 381 are separated from the peripheral portion of the laminated substrate Ws, so that the laminated substrate Ws can be released from the four rollers 381. The released laminated substrate Ws is transferred for the next process by a transfer device not shown.

The application process of the filler F by use of the application unit 301A and the cure process of the filler F by use of the curing unit 301B are performed while rotating the laminated substrate Ws, which is held in the horizontal state by the rotary-holding mechanism 303.

In one embodiment, the roller rotation mechanism may be configured to rotate only some of the rollers 381. For example, the roller rotation mechanism may be coupled to two of the four rollers 381, and configured to rotate those two rollers 381 in the same direction and at the same speed. In this case, the other two rollers 381 are configured to be freely rotatable. When two of the rollers 381 coupled to the roller rotation mechanism are rotated with the four rollers 381 in the hold position, the other two rollers 381 rotate through the laminated substrate Ws in accordance with the rotation of rollers 381 coupled to the roller rotation mechanism.

In one embodiment, the roller movement mechanism may be configured to move only some of the rollers 381. For example, the roller movement mechanism may be coupled to two of the four rollers 381, and move those two rollers 381 between the hold position and the release position. In this case, the other two rollers 381 are fixed in advance in the hold position. The laminated substrate Ws is transferred by the transfer device to a position where the peripheral portion of the laminated substrate Ws contacts the two fixed rollers 381. When the roller movement mechanism moves the two rollers 381 coupled to the roller movement mechanism to the hold position, the laminated substrate Ws can be held in the horizontal state. When the roller movement mechanism moves the two rollers 381 coupled to the roller movement mechanism to the release position, the laminated substrate Ws can be released.

In the embodiments described above, the rotary-holding mechanism 303 is configured to hold the laminated substrate Ws horizontally. More specifically, the laminated substrate Ws is held in the horizontal state by the rotary-holding mechanism 303. The application of the filler F by the application unit 301A and the curing of the filler F by the curing unit 301B are performed while rotating the laminated substrate Ws, which is held in the horizontal state by the rotary-holding mechanism 303. However, as long as the filler F can be applied into the gap formed between the peripheral portions of adjacent wafers W1 and W2 (and also the gap formed between the peripheral portions of adjacent wafers W2 and W3, and the gap between the peripheral portions of adjacent laminated wafer Ws' and a fourth wafer W4), the method of holding the laminated substrate Ws is not limited to the embodiments described above. For example, the filler-application module 300 may have a rotary-holding mechanism 303 configured to hold the laminated substrate Ws vertically (in a vertical state). When the laminated substrate Ws is held in a vertical state, the upper surface and the lower surface of the laminated substrate Ws are in virtual planes extending in a vertical direction perpendicular to the horizontal direction, respectively.

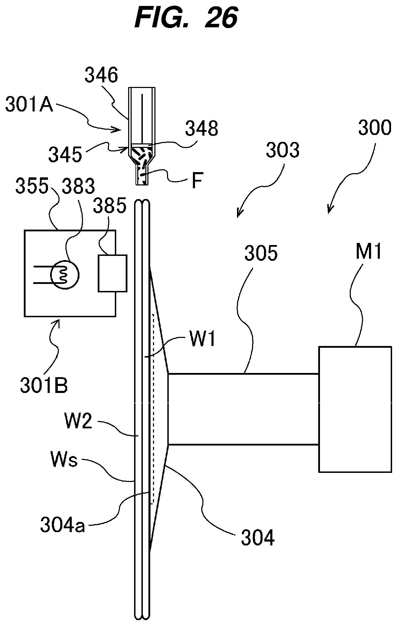

FIG. 25 is a side view showing the filler module according to still another embodiment. FIG. 26 is a view viewed from a direction indicated by an arrow A in FIG. 25. Configurations of this embodiment, which will not be particularly described, are the same as those of the embodiments described above, and redundant descriptions thereof will be omitted. FIG. 25 represents a view of the rotary-holding mechanism 303 viewed from a back side of the laminated substrate Ws. The rotary-holding mechanism 303 in this embodiment differs from the embodiments described above in that the holding stage 304, the hollow shaft 305, and the motor M1 are configured to be able to hold the laminated substrate Ws in a vertical state.

The holding stage 304 is configured to hold the back surface of the laminated substrate Ws by vacuum suction. As shown in FIG. 26, the upper surface of the holding stage 304, which holds the back surface of the laminated substrate Ws, is a surface perpendicular to the horizontal plane, and a groove 304a is formed on this upper surface. The laminated substrate Ws is held so as to be perpendicular to the horizontal plane. More specifically, the laminated substrate Ws is held in the vertical state by the holding stage 304 of the rotary-holding mechanism 303.

The hollow shaft 305 is coupled to a center portion of the holding stage 304. The laminated substrate Ws is held onto the holding stage 304 so that the center of the laminated substrate Ws is aligned with a central axis of the hollow shaft 305. The motor M1 is configured to rotate the holding stage 304 and the laminated substrate Ws in unison around a central axis Cr of the laminated substrate Ws in a direction indicated by an arrow in FIG. 25.

The filler-application module 300 includes an application-module movement mechanism (not shown) configured to move the application unit 301A. The application-module movement mechanism is configured to move the application unit 301A between an application position, where the filler is applied, and a standby position, where the application of the filler is prohibited. For example, the standby position of the application unit 301A is set at a position farther from the laminated substrate Ws than the application position so as not to interfere with operations of other devices, such as the transfer of the laminated substrate Ws.

In this embodiment, the application position of the application unit 301A is a position that is located above the laminated substrate Ws held on the holding stage 304, and faces the gap between the peripheral portions of the adjacent wafers W1 and W2. When the application unit 301A in the application position discharges the filler, the filler falls toward the gap formed in the laminated substrate Ws, and as a result, the filler can be applied into the gap of the laminated substrate Ws. In this embodiment, the standby position is set at a position farther outward in a radial direction of the laminated substrate Ws than the application position. FIGS. 25 and 26 illustrate the state in which the application unit 301A is placed in the application position.

In this embodiment also, the rotary-holding mechanism 303 and the application-module movement mechanism are coupled to the controller 113 (see FIG. 1), and the controller 113 is configured to be able to control operations of the rotary-holding mechanism 303 and the application-module movement mechanism.

When the filler F is applied into the gap formed in the laminated substrate Ws by the application unit 301A, the application-module movement mechanism moves the application unit 301A to the application position. The application-module movement mechanism may be configured to be able to control a distance between the application unit 301A and the laminated substrate Ws. For example, the controller 113 may control the distance between the application unit 301A and the laminated substrate Ws using the application-module movement mechanism according to a physical property, such as viscosity of the filler F, such that the filler F is properly applied into the gap in the laminated substrate Ws.

As shown in FIG. 25, the curing unit 301B is arranged downstream of the application unit 301A in a direction of rotation of the laminated substrate Ws. Similar to the embodiments described above, the curing unit 301B is configured to cure the filler F applied into the gap of the laminated substrate Ws by the application unit 301A. In one embodiment, the filler-application module 300 may include a curing-module movement mechanism (not shown) configured to move the curing unit 301B between a curing position, where curing of the filler is performed, and a standby position, where the curing unit 301B is farther from the laminated substrate Ws than the curing position. Examples of curing-module movement mechanism may include a piston-cylinder mechanism, and a combination of ball screw and motor (i.e., stepping motor).

The application process of the filler F by the application unit 301A and the curing process of the filler F by the curing unit 301B are performed while rotating the laminated substrate Ws which is held in the vertical state by the holding stage 304.

In one embodiment, the filler-application module 300 may be arranged so as to place the application unit 301A and the curing unit 301B to be adjacent to the laminated substrate Ws held on the holding stage 304, without providing the application-module movement mechanism (and the curing-module movement mechanism). In this case, the distance between the application unit 301A and the laminated substrate Ws and the distance between the curing unit 301B and the laminated substrate Ws are determined in advance such that the filler is properly injected and cured in the gap formed in the laminated substrate Ws.

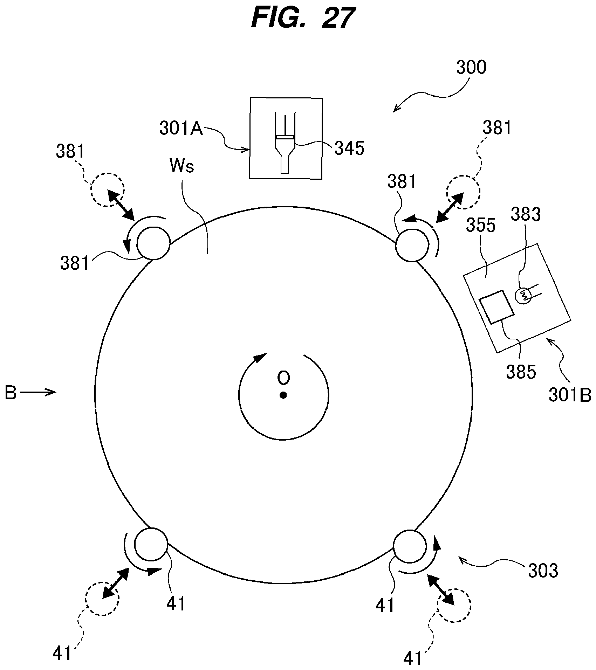

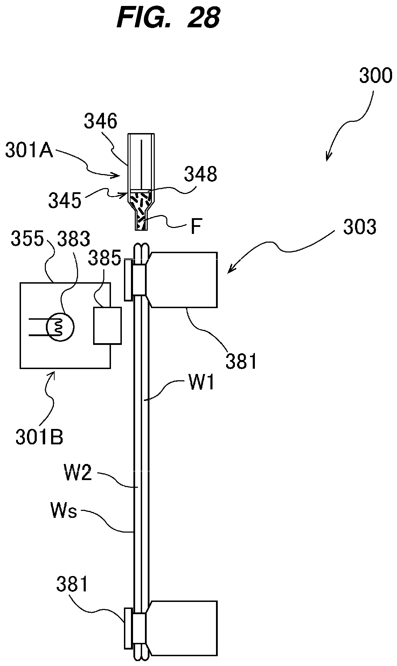

FIG. 27 is a side view showing the filler-application module according to still another embodiment. FIG. 28 is a view viewed from a direction indicated by an arrow B in FIG. 27. Configurations of this embodiment, which will not be particularly described, are the same as those of the embodiments described with reference to FIGS. 23 and 24, and redundant descriptions thereof will be omitted. In this embodiment, three or more (four in this embodiment) rollers 381 are configured to contact the peripheral portion of the laminated substrate Ws to hold the laminated substrate Ws vertically. More specifically, the laminated substrate Ws is held in a vertical state by the roller 381 of the rotary-holding mechanism 303. As shown in FIG. 28, when the laminated substrate Ws is held in the vertical state by the roller 381 of the rotary-holding mechanism 303, the upper surface and the lower surface of the laminated substrate Ws are in the virtual planes extending in the vertical direction, respectively.

In this embodiment also, the roller rotation mechanism is coupled to the four rollers 381, and is configured to rotate the four rollers 381 in the same direction and at the same speed. Configuration of the roller rotation mechanism is freely selected as long as the roller rotation mechanism can rotate three or more rollers 381 in the same direction and at the same speed, and thus any known rotation mechanism can be used as the roller rotation mechanism. Examples of the roller rotation mechanism may include a combination of motor, pulley (and/or gear), and rotation belt.

The roller movement mechanism is coupled to the four rollers 381, and is configured to move each of the rollers 381 in directions approaching toward and away from the reference center point O of the rotary-holding mechanism 303. The roller movement mechanism enables the four rollers 381 to be moved between a holding position (see solid line in FIG. 27), where the peripheral portion of the laminated substrate Ws is held by the rollers 381, and a release position (see dotted line in FIG. 27), where the laminated substrate Ws is released from the rollers 381. Configuration of the roller movement mechanism is freely selected as long as the four rollers 381 can be moved between the holding position and the release position, and thus any known movement mechanism can be used as the roller movement mechanism. Examples of the roller movement mechanism may include a piston-cylinder mechanism, and a combination of ball screw and motor (i.e., stepping motor).

The roller rotation mechanism and the roller movement mechanism of the rotary-holding mechanism 303 are electrically coupled to the controller 113 (see FIG. 1), and operations of the roller rotation mechanism and the roller movement mechanism of the rotary-holding mechanism 303 are controlled by the controller 113.

The laminated substrate Ws is transferred by a transfer device, not shown, to a position where the axis center of the laminated substrate Ws is aligned with the reference center point O of the rotary-holding mechanism 303. At this time, the rollers 381 are in the release position. Next, the roller movement mechanism moves the four rollers 381 to the holding position, so that the peripheral portion of the laminated substrate Ws is held by the four rollers 381. This operation causes the laminated substrate Ws to be held in the vertical state by the four rollers 381. When the four rollers 381 moved to the holding position are rotated by the roller rotation mechanism, the laminated substrate Ws is rotated around the axis center thereof.

When the four rollers 381 in the holding position are moved to the release position by the roller movement mechanism, the four rollers 381 are separated from the peripheral portion of the laminated substrate Ws, so that the laminated substrate Ws can be released from the four rollers 381. The released laminated substrate Ws is transferred for the next processing by the transfer device, not shown.

The application process of the filler F by the application unit 301A and the curing process of the filler F by the curing unit 301B are performed while rotating the laminated substrate Ws which is held vertically by the rotary-holding mechanism 303.

In one embodiment, the roller rotation mechanism may be configured to rotate only some of the rollers 381. For example, the roller rotation mechanism may be coupled to two of the four rollers 381, and be configured to rotate those two rollers in the same direction and at the same speed. In this case, the other two rollers 381 are configured to rotate freely. When two of the rollers 381 coupled to the roller rotation mechanism are rotated with the four rollers 381 in the hold position, the other two rollers 381 rotate through the laminated substrate Ws in accordance with the rotation of rollers 381 coupled to the roller rotation mechanism.

In one embodiment, the roller movement mechanism may be configured to move only some of the rollers 381. For example, the roller movement mechanism may be coupled to two of the four rollers 381, and is configured to move these two rollers 381 between the hold position and the release position. In this case, the other two rollers 381 are fixed in advance in the hold position. The laminated substrate Ws is transferred by the transfer device to a position where the peripheral portion of the laminated substrate Ws contacts the two fixed rollers 381. The roller movement mechanism moves the two rollers 381 coupled to the roller movement mechanism to the hold position, so that the laminated substrate Ws can be held in a vertical state. When the two rollers 381 coupled to the roller movement mechanism are moved by the roller movement mechanism to the release position, the laminated substrate Ws can be released.

The previous description of embodiments is provided to enable a person skilled in the art to make and use the present invention. Moreover, various modifications to these embodiments will be readily apparent to those skilled in the art, and the generic principles and specific examples defined herein may be applied to other embodiments. Therefore, the present invention is not intended to be limited to the embodiments described herein but is to be accorded the widest scope as defined by limitation of the claims.

### Industrial Applicability

The invention is applicable to a substrate processing apparatus and a substrate processing method of processing a laminated substrate manufactured by bonding a plurality of substrates.

### Reference Signs List

- 101: loading-and-unloading section
- 102: front loading unit
- 103: first transfer robot
- 200: substrate transfer module
- 300: first processing module (filler-application module)
- 301A: application unit
- 301B: curing module
- 400: second processing module (back-grinding module)
- 410: spindle
- 412: grinding head
- 500: second processing module (polishing module)
- 505: polishing head
- 510: polishing pad
- 550: buff-process component
- 552: buff pad
- 700: fourth processing module (polishing module)
- 800: fifth processing module (filler-removal module)
- 811: polishing head assembly
- 812: polishing-tape supply-and-recovery mechanism

## Claims

1. A substrate processing apparatus for processing a laminated substrate manufactured by bonding a plurality of wafers to each other, comprising:
a filler-application module configured to apply and cure a filler to a gap between peripheral portions of adjacent wafers of the plurality of wafers;
a grinding module configured to grind an upper surface of the laminated substrate to which the filler has been applied; and
a polishing module configured to polish an upper surface of the laminated substrate that has been ground.

2. The substrate processing apparatus according to claim 1, wherein the polishing module comprises:
a polishing table configured to support a polishing pad;
a polishing head configured to hold the laminated substrate and press the upper surface of the laminated substrate against the polishing pad; and
a polishing-liquid supply nozzle configured to supply a polishing liquid to the polishing pad.

3. The substrate processing apparatus according to claim 2, further comprising: a substrate transfer module configured to transfer the laminated substrate from the grinding module to the polishing module while inverting an upper surface and a lower surface of the laminated substrate.

4. The substrate processing apparatus according to claim 1, wherein the polishing module, the grinding module, and the polishing module are arranged adjacent to each other along a direction of transferring the substrate.

5. The substrate processing apparatus according to claim 1, further comprising: a finish-polishing module configured to further polishing the laminated substrate that have been polished.

6. The substrate processing apparatus according to claim 5, wherein the finish-polishing module comprises:
a polishing table configured to support a polishing pad;
a polishing head configured to hold the laminated substrate and to press an upper surface of the laminated substrate against the polishing pad; and
a polishing-liquid supply nozzle configured to supply a polishing liquid to the polishing pad.

7. The substrate processing apparatus according to claim 1, further comprising: a filler-removal module configured to remove the filler from the laminated substrate that has been ground.

8. The substrate processing apparatus according to claim 7, wherein the filler-removal module comprises:
a substrate holder configured to hold and rotate the laminated substrate; and
a filler-removal unit configured to press a polishing tape against the peripheral portion of the laminated substrate to thereby remove the filler.

9. The substrate processing apparatus according to claim 8, wherein the filler-removal module further comprises: a removal-agent supply mechanism configured to supply a removal agent, which can dissolve the filler, to the laminated substrate.

10. The substrate processing apparatus according to claim 7, wherein the filler-removal module comprises:
a substrate holder configured to hold and rotate the laminated substrate; and
a removal-agent supply mechanism configured to supply a removal agent, which can dissolve the filler, to the laminated substrate.

11. The substrate processing apparatus according to claim 7, wherein the filler-removal module comprises: a buff-process component configured to finish-polish to the upper surface of the laminated substrate that has been polished,
the buff-process component comprises:
a buff head to which the buff pad for executing a buff process to the upper surface of the laminated substrate is mounted; and
a buff arm configured to hold the buff head so as to allow the buff head to swing in a radial direction of the laminated substrate.

12. The substrate processing apparatus according to claim 7, wherein the filler-application module includes:
a rotary-holding mechanism configured to hold the laminated substrate in a vertical state;
an application module configured to apply the filler into the gap in the laminated substrate above the laminated substrate held by the rotary-holding mechanism; and
a curing module configured to cure the filler applied by the application module.

13. A substrate processing method, comprising:
taking out a laminated substrate, which is manufactured by bonding a plurality of wafers to each other, from a substrate cassette;
applying and curing a filler to a gap between peripheral portions of adjacent wafers of the plurality of wafers;
grinding an upper surface of the laminated substrate to which the filler has been applied;
polishing an upper surface of the laminated substrate that has been ground; and
returning the laminated substrate that has been polished, to the substrate cassette.

14. The substrate processing method according to claim 13, further comprising: removing the filler from the laminated substrate that has been ground.

15. The substrate processing method according to claim 14, removing the filler is performed after polishing the upper surface of the laminated substrate.

16. The substrate processing method according to claim 14, removing the filler is performed before polishing the upper surface of the laminated substrate.

17. The substrate processing method according to claim 14, removing the filler is removing the filler by pressing a polishing tape against the peripheral portion of the laminated substrate while rotating the laminated substrate.

18. The substrate processing method according to claim 14, removing the filler is performed by supplying a removal agent, which can dissolve the filler, to the laminated substrate while rotating the laminated substrate.

19. The substrate processing method according to claim 13, grinding the upper surface of the laminated substrate and polishing the laminated substrate is performed in the same processing module.

20. The substrate processing method according to claim 13, further comprising: inverting an upper surface and a lower surface of the laminated substrate after grinding the upper surface of the laminated substrate,
wherein polishing of the laminated substrate is pressing the upper surface of the laminated substrate against a polishing pad, while rotating a polishing table configured to support the polishing pad and supplying a polishing liquid onto the polishing pad.

21. The substrate processing method according to claim 20, further comprising: finish-polishing the upper surface of the laminated substrate after polishing the upper surface of the laminated substrate,
wherein finish-polishing of the laminated substrate is pressing the upper surface of the laminated substrate against a polishing pad, while rotating a polishing table configured to support the polishing pad and supplying a polishing liquid onto the polishing pad, and
the polishing pad in finish-polishing of the laminated substrate has a finer polishing surface than a polishing surface of the polishing pad in polishing of the laminated substrate.

22. The substrate processing method according to claim 20, further comprising: finish-polishing the upper surface of the laminated substrate after polishing the upper surface of the laminated substrate,
wherein finish-polishing of the laminated substrate is pressing the upper surface of the laminated substrate against a polishing pad, while rotating a polishing table configured to support the polishing pad and supplying a polishing liquid onto the polishing pad, and
abrasive grains contained in a polishing liquid for finish-polishing of the laminated substrate have a smaller grain size than abrasive grains contained in a polishing liquid for polishing of the laminated substrate.

23. The substrate processing method according to claim 21, finish-polishing the laminated substrate and removing the filler is performed in the same processing module.

24. The substrate processing method according to claim 13, applying and curing the filler is performed while rotating the laminated substrate held in a vertical state.
